(19) **Europäisches Patentamt / European Patent Office / Office européen des brevets**

(11) **EP 4 513 767 A1**

(12) **EUROPEAN PATENT APPLICATION**
published in accordance with Art. 153(4) EPC

(43) Date of publication:
**26.02.2025 Bulletin 2025/09**

(21) Application number: **23803696.6**

(22) Date of filing: **03.04.2023**

(51) International Patent Classification (IPC):
**H03M 13/13** (2006.01)   **H03M 13/39** (2006.01)
**H03M 13/00** (2006.01)

(52) Cooperative Patent Classification (CPC):
**H03M 13/00; H03M 13/13; H03M 13/39**

(86) International application number:
**PCT/KR2023/004482**

(87) International publication number:
**WO 2023/219271 (16.11.2023 Gazette 2023/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.05.2022  KR 20220056313**
**09.05.2022  KR 20220056917**
**04.11.2022  KR 20220146143**

(71) Applicant: **Samsung Electronics Co., Ltd.**
**Suwon-si, Gyeonggi-do 16677 (KR)**

(72) Inventors:
• **JANG, Min**
  **Suwon-si Gyeonggi-do 16677 (KR)**
• **KIM, Jonghwan**
  **Suwon-si Gyeonggi-do 16677 (KR)**
• **MYUNG, Seho**
  **Suwon-si Gyeonggi-do 16677 (KR)**

(74) Representative: **HGF**
  **HGF Limited**
  **1 City Walk**
  **Leeds LS11 9DX (GB)**

(54) **DEVICE AND METHOD FOR DECODING POLAR CODES BY USING FUTURE CONSTRAINTS IN COMMUNICATION SYSTEM OR BROADCASTING SYSTEM**

(57)   In embodiments of the present disclosure, a device performed by a device in a communication system or a broadcasting system may comprise a memory, at least one transceiver and at least one processor. The at least one processor can be configured to: receive a signal including bits encoded on the basis of polar codes; identify a polar code configuration for at least one information bit and at least one frozen bit of the signal; and decode the signal on the basis of the configuration of the polar codes.

EP 4 513 767 A1

FIG. 6

**Description**

**[Technical Field]**

The disclosure generally relates to a device and a method for decoding a signal transmitted using polar codes in a communication system or a broadcasting system. More particularly, the disclosure relates to using at least one future constraint in a device and a method for decoding a transmitted signal using polar codes.

**[Background Art]**

In general, when data is transmitted and received between a transmitter and a receiver in a communication and broadcasting system, a data error may occur due to noise present in a communication channel. As such, there are an error detection code (ECC) scheme and an error correction codes (ECC) scheme as an encoding method designed to allow a receiver to process such an error generated by a communication channel. The error detection code scheme is a technique that allows the receiver to check whether an error is included in its received data, and the error correction code scheme is a technique that allows the receiver to correct the error included in the received data by itself. Here, the error correction coding scheme is also commonly referred to as a channel coding or a forward error correction (FEC).
There are various schemes for error correction coding. Typical error correction codes include a convolutional code, a turbo code, a low-density parity-check code (LDPC code), and a polar code method. In particular, turbo codes, LPDC codes, and polar codes are excellent channel codes that have the performance close to or achieve its theoretical channel capacity as widely used in various communication and broadcasting systems today.
The following reference documents are cited in the disclosure.

[1] E. Arikan, "Channel Polarization: a method for constructing capacity-achieving codes for symmetric binary-input memoryless channels," IEEE Trans. Information Theory, vol. 55, no. 7, pp. 3051-3073, July 2009.
[2] 3GPP, NR multiplexing and channel coding(Release 15), TSG RAN TS38.212 v15.0.1, Feb. 2017.
[3] A. Balatsoukas-Stimming, M. B. Parizi, and A. Burg, "LLR-based successive cancellation list decoding of polar codes," IEEE Trans. Sig. Process., vol. 63, no. 19, pp. 5165 - 5179, June 2015.

Polar codes of the error correction code techniques is a channel code that achieves a point-to-point channel capacity in a simple and effective manner using a phenomenon called channel polarization[1]. When an encoding using a structured generator matrix and a successive cancellation (SC) decoding are used in a process of transmitting a plurality of bits via an independent bit channel, a channel for each bit is transformed into a virtual polarized synthesized channel. In this process, some synthesized channels become good channels close to 1 with a maximum channel capacity, while the remaining synthesized channels become poor channels close to 0 with a minimum channel capacity. The total sum of the channel capacities of the synthesized channels remains the same before and after transformation. Since the channel polarization is maximized as a code length increases, a good channel has a channel capacity of 1 and a poor channel has a channel capacity of 0. Accordingly, a transmitter may theoretically achieve a channel capacity for a given channel easily and effectively, by transmitting an information bit to be transmitted to the good channel and allocating a frozen bit to the bad channel.
The SC decoding scheme for the polar code may be easily modified and extended to a near-ML or ML-like decoding scheme such as e.g., SC-list (SCL) decoding, SC-stack (SCS) decoding, SC-flip (SCF) decoding, or the like. Such an improved decoding algorithm may achieve better error correction performance. For this reason, 3GPP NR of a 5G communication standard, uses a polar code upon transmitting a short-length of control information[2].
The above information is presented as background information only to assist with an understanding of the disclosure. No determination has been made, and no assertion is made, as to whether any of the above might be applicable as prior art with regard to the disclosure.

**[Detailed Description of Invention]**

**[Technical Solution]**

According to embodiments of the disclosure, a method performed by a device in a communication system or a broadcasting system may include receiving a signal including bits encoded based on polar codes. The method may include identifying a polar code configuration for at least one information bit and at least one frozen bit of the signal. The method may include decoding the signal based on the configuration of the polar codes. The decoding of an information bit of the at least one information bit may be performed based on at least one value of at least one constraint bit. The at least one constraint bit may include at least one of a parity bit or a frozen bit corresponding to a sequence subsequent to the information bit.

According to embodiments of the disclosure, a device performed by an apparatus in a communication system or a broadcasting system may include a memory, at least one transceiver, and at least one processor. The at least one processor may be configured to receive a signal including bits encoded based on polar codes. The at least one processor may be configured to identify a polar code configuration for at least one information bit and at least one frozen bit of the signal. The at least one processor may be configured to perform decoding of the signal, based on the polar code configuration. The decoding of an information bit of the at least one information bit may be performed based on at least one value of at least one constraint bit. The at least one constraint bit may include at least one of a parity bit or a frozen bit corresponding to a sequence subsequent to the information bit.

**[Brief Description of Drawings]**

FIG. 1 illustrates a communication system or a broadcasting system according to embodiments of the disclosure.

FIG. 2 illustrates an example of a configuration of a receiving-end device in a communication system or a broadcasting system according to embodiments of the disclosure.

FIG. 3 illustrates an example of a graph corresponding to polar codes in a communication system or a broadcasting system according to embodiments of the disclosure.

FIG. 4 illustrates an elemental process of performing a log-likelihood ratio (LLR) operation and its successive cancellation in a polar code decoding method and device of a communication system or a broadcasting system according to an embodiment of the disclosure.

FIG. 5 illustrates an example of a binary decision tree for sequentially decoding and estimating bits in a polar code decoding method and device of a communication system or a broadcasting system according to embodiments of the disclosure.

FIG. 6 illustrates an example of a binary decision tree considered in a polar code decoding method and device of a communication system or a broadcasting system according to embodiments of the disclosure.

FIG. 7 illustrates the performance of a decoding technique according to embodiments of the disclosure.

FIG. 8 illustrates an example of a binary decision tree used in a polar code decoding method and a device of a communication system or a broadcasting system according to embodiments of the disclosure.

FIG. 9 illustrates an example of a graph modified in consideration of future constraints in a polar code decoding method and device of a communication system or a broadcasting system according to embodiments of the disclosure.

FIG. 10 illustrates an example of a graph considering future constraints configured upon decoding each bit in a polar code decoding method and device of a communication system or a broadcasting system according to embodiments of the disclosure.

FIG. 11 illustrates another example of a graph considering future constraints configured upon decoding each bit in a polar code decoding method and device of a communication system or a broadcasting system according to embodiments of the disclosure.

FIG. 12 illustrates an operation flow of a device for decoding based on future constraints according to embodiments of the disclosure.

FIG. 13 illustrates an example of a concatenated polar coding system using an outer code according to embodiments of the disclosure.

FIG. 14 illustrates an example of an equivalent model of a concatenated polar coding system using an outer code according to embodiments of the present disclosure.

FIG. 15 illustrates an example of an intermediate codeword vector according to embodiments of the disclosure.

**[Mode For Carrying Out Invention]**

Hereinafter, embodiments of the disclosure will be described in greater detail with reference to the accompanying drawings.

In describing embodiments, description of technical contents that are well known in the technical field to which the disclosure pertains and are not directly related to the disclosed invention will be omitted. This is to convey the subject matter of the disclosed invention more clearly without obscuring the same by omitting unnecessary description.

For the same or similar reasons, some elements in the accompanying drawings may be emphasized, omitted, or schematically illustrated. Further, the size of each component may not entirely reflect the actual size. In the drawings, the same or like components are denoted by the same reference numerals.

Advantages and features of the disclosure and methods of achieving the same will become apparent, referring to the embodiments described below in detail with reference to the accompanying drawings. However, the disclosure is not limited to the embodiments disclosed below, but may be implemented in various different forms, and the present disclosure is provided only to make the disclosure more complete and to fully inform a person skilled in the art of the scope of the claimed invention, which is defined only by the scope of the claims. Throughout the specification, the same reference numerals refer to the same components.

In this context, it will be understood that operations of each block of the flowcharts and combinations of the blocks in the flowcharts may be performed by computer program instructions. Since those computer program instructions may be mounted on a processor of a general-purpose computer, a special-purpose computer, or other programmable data processing equipment, the computer may also generate a means by which the instructions executed via the processor of the other programmable data processing equipment perform the functions described in block(s) of the flowcharts. These computer program instructions may be stored in a computer-usable or computer-readable memory that may be directed to a computer or other programmable data processing equipment to implement a function in a specific manner, and thus the instructions stored in the computer-usable or computer-readable memory may also produce a manufacturing item including therein instruction means that perform the function described in the flowchart block(s). The computer program instructions may be mounted onto a computer or any other programmable data processing equipment, and therefore, the instructions causing the computer or other programmable data processing equipment to perform a series of steps of operation thereon to create a process executable by the computer may also provide steps for performing the functions described in the flowchart block(s).

Further, each block may represent a module, a segment, or a portion of a code including one or more executable instructions for executing a specified logical function(s). It should also be noted that in some alternative execution examples, the functions mentioned in the blocks may occur out of the sequence. For example, two blocks shown one after another may actually be performed substantially simultaneously, or the blocks may sometimes be performed in reverse order depending on their corresponding functions.

In this context, the term '~ unit (or part)' used in embodiments of the disclosure may mean software or a hardware component such as e.g., FPGA or ASIC, to perform a certain function. However, the '~ unit' does not mean that it is limited only to such software or hardware. The '~ unit' may be configured to reside in an addressable storage medium or may be configured to reproduce one or more processors. Thus, as an example, the '~ unit' may include components such as e.g., software components, object-oriented software components, class components, and task components, processes, functions, attributes, procedures, subroutines, segments of program code, drivers, firmware, micro-codes, circuits, data, databases, data structures, tables, arrays, variables and so on. Functions provided within those components and the '~ unit' may be combined into a smaller number of components and '~ units (or parts)' or may be further separated into additional components and '~ units (or parts)'. In addition, the components and '~units (or parts)' may be implemented to reproduce one or more CPUs in a device or a secure multimedia card.

Hereinafter, various embodiments will be described in detail below with reference to the accompanying drawings, wherein it should be noted that in the accompanying drawings, the same components are denoted by the same reference numerals wherever possible. It should also be noted that the accompanying drawings of the disclosure are provided to assist in understanding the present invention, and that the disclosed invention is not limited only to the form or arrangement illustrated in the accompanying drawings. Furthermore, detailed descriptions of the known features and configurations that may obscure the subject matter of the disclosed invention will be omitted for convenience of explanation. It should be understood that in the following description, only those portions necessary to understand the operation of various embodiments of the disclosed invention will be described, and description of the other portions will be omitted so as not to obscure the gist of the disclosed invention.

In the following description, terms referring to signals (e.g., signals, information, messages, signaling), terms referring to resources, terms for operation states (e.g., steps, operations, procedures), terms referring to data (e.g., packets, user streams, information, bits, symbols, codewords), terms referring to channels, terms referring to network entities, terms referring to components of a device or apparatus, and the like are exemplified only for convenience of description. Therefore, the disclosure is not limited to the terms to be described below, and other terms having equivalent technical meanings may be used.

Throughout the disclosure, an expression such as e.g., 'more than' or 'less than' may be used to determine whether a specific condition is satisfied or fulfilled or not, but it is merely of a description for expressing an example and is not intended to exclude the meaning of 'more than or equal to' or 'less than or equal to'. A condition described as 'more than or equal to' may be replaced with 'more than', a condition described as 'less than or equal to' may be replaced with 'less than', and a condition described as 'more than or equal to and less than' may be replaced with 'more than and less than or equal to', respectively. Further, hereinafter, 'A' to 'B' may refer to at least one of the elements from A (including A) to B (including B). Hereinafter, 'C' and/or 'D' may refer to including at least one of 'C' or 'D', that is, {'C', 'D', or 'C' and 'D'}.

In the disclosure, while some embodiments of the disclosure are described using the terms used in some communication standards (e.g., 3rd Generation Partnership Project (3GPP)), they are only of examples for description. Various embodiments of the disclosure may be easily modified and applied to other communication systems.

In the disclosure, a communication and broadcasting system is considered using polar codes. A basic decoding scheme of polar codes is a successive-cancellation (SC), characterized in that an encoding input bit sequence is sequentially decoded by one bit based on values of previously estimated bits. SC decoding is, in use, modified and extended to an improved algorithm such as e.g., SC-list (SCL) decoding, SC-stack (SCS) decoding, and SC-flip (SCF) decoding, and these algorithms are also fundamentally based on a successive cancellation scheme of sequentially decoding bits.

The disclosure is related to a method and a device for improving its characteristics and performance by overcoming a portion that has not yet been considered in a conventional SC-based successive decoding for polar codes, using a realistic method. The SC decoding proposed in the article "E. Arikan, "Channel Polarization: a method for constructing capacity-achieving codes for symmetric binary-input memoryless channels", IEEE Trans. Information Theory, vol. 55, no. 7, pp. 3051-3073, July 2009 [1]" is established assuming that in a step of decoding a specific bit, bits to be subsequently decoded may have a value of 0 or a value of 1 without being constrained. However, in case of configuring polar codes, constrained bits such as at least one frozen bit (or a fixed bit), a parity bit or the like may exist among the bits to be decoded. Therefore, in the decoding step of the specific bit, at least one constrained bit may be included among the bits to be subsequently decoded. The SC decoding is not strictly an optimal decoding method because it does not take into account such constrained bits that may exist later upon construction of the code, as described above. Such an issue having been discovered, the disclosure proposes methods and embodiments for improving the SC decoding method and device in consideration of the constraints that exist afterwards in decoding of a specific bit, in short, the future constraints, using a realistic way.

A device and a method according to embodiments of the disclosure may improve error correction performance by performing decoding based on at least one future constraint.

The effects that can be obtained from the disclosure are not limited to those mentioned above, and other effects not mentioned herein may be clearly understood by those having ordinary knowledge in the technical field to which the disclosure belongs from the following description.

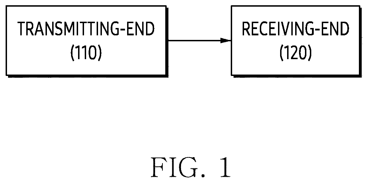

FIG. 1 illustrates a communication system and a broadcasting system according to embodiments of the disclosure.

Referring to FIG. 1, a transmitting-end 110 and a receiving-end 120 are illustrated as a part of devices or nodes using a wireless channel in a wireless communication system. FIG. 1 illustrates one transmitting-end 110 and one receiving-end 120, but a communication system or a broadcasting system may include a plurality of transmitting-ends or a plurality of receiving-ends. Further, in the disclosure, it is described for convenience of description that the transmitting-end 110 and the receiving-end 120 are separate entities, but the functions of the transmitting-end 110 and the receiving-end 120 may be interchanged. For example, in the case of an uplink of a cellular communication system, the transmitting-end 110 may be a terminal and the receiving-end 120 may be a base station. Similarly, in the case of a downlink thereof, the transmitting-end 110 may be a base station, and the receiving-end 120 may be a terminal.

A base station is a network infrastructure that provides wireless access to a terminal. The base station has a coverage defined based on a range capable of transmitting a signal. In addition to the term 'base station', the base station may be referred to 'massive multiple input multiple output (MIMO) unit (MMU)', 'access point (AP)', 'eNodeB (eNB)', '5th generation node (5G) node', '5G nodeB (NB)', 'wireless point', 'transmission/reception point (TRP)', 'access unit', 'distributed unit (DU)', 'transmission/reception point (TRP)', 'radio unit (RU)', 'remote radio head (RRH), or other terms having a technical meaning equivalent thereto. The base station may transmit a downlink signal or receive an uplink signal.

A terminal is a device used by a user to communicate with the base station through a wireless channel. In some cases, the terminal may be operated without any user involvement. That is, the terminal is a device that performs machine type communication (MTC) and may not be carried by a user. In addition to the term 'terminal', the terminal may be referred to as 'user equipment (UE)', 'mobile station', 'subscriber station', 'customer premises equipment (CPE)', 'remote terminal', 'wireless terminal', 'electronic device', 'vehicle terminal', 'user device' or any other term having a technical meaning equivalent thereto.

Although not shown in FIG. 1, the terminal may perform direct communication with another terminal in addition to communication between the base station and the terminal. For example, a vehicle communication may be supported between the terminal illustrated in FIG. 1 and another terminal. For the vehicle communication, in the LTE system, a standardization work for V2X technology based on a device-to-device (D2D) communication structure has been finalized in the 3GPP Release 14 and Release 15, and a standardization work for the NR V2X technology has been currently performed in the 5G NR Release 16.

A transmitting-end and a receiving-end may be defined in a various way according to a link established between communication nodes. According to an embodiment, the transmitting-end 110 may be a base station, and the receiving-end 120 may be a terminal. Further, according to another embodiment, the receiving-end 120 may be a base station, and the transmitting-end 110 may be a terminal. Further, according to another embodiment, both the transmitting-end and the receiving-end may be terminals. Hereinafter, the disclosure describes a subject transmitting a signal as a transmitting-end and a subject receiving a signal as a receiving-end, but it is merely of a functional expression for describing a signal processing process, and the disclosure is not interpreted as limiting to a specific embodiment.

In embodiments, the transmitting-end 110 may encode information bits based on polar codes to generate a codeword, and the receiving-end 120 may decode a signal of the received codeword based on the polar codes. A sub-channel allocation for input bits may be performed. Each input bit may be interpreted as passing through a sub-channel (or a split channel), which is a virtual channel of different quality, by channel polarization. At this time, each sub-channel is also referred to as a synthetic channel. After the sub-channel allocation, the transmitting-end 110 may perform encoding based on the polar codes using a generation matrix. The receiving-end 120 may perform decoding based on polar codes through successive decoding (SC).

In embodiments, the transmitting-end 110 may generate a codeword by encoding information bits based on the LDPC code. The receiving-end 120 may decode a signal of the received codeword based on the LDPC code. For example, the receiving-end 120 may use an LDPC decoding scheme according to the present disclosure, and may perform a syndrome check to determine whether a result of the decoding is normal. The transmitting-end 110 may perform LDPC encoding using a parity check matrix. The receiving-end 120 may perform LDPC decoding using the parity check matrix. For example, the parity check matrix may include a parity check matrix defined in the 3GPP NR standard.

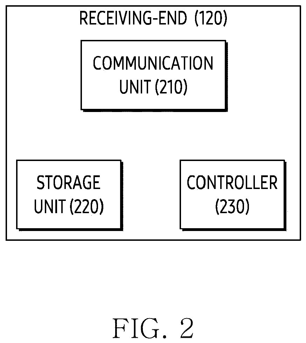

FIG. 2 illustrates an example of a configuration of a receiving-end device in a communication system or a broadcasting system according to embodiments of the disclosure. In other words, the configuration illustrated in FIG. 2 may be understood as a configuration of the receiving-end 120. As used hereinafter, the term such as '~ unit', '~ module', '~ part' or the like may refer to a unit adapted to process at least one function or operation, and may be implemented by hardware, software, or a combination of hardware and software.

Referring to FIG. 2, a device may include a communication unit 210, a storage unit 220, and a controller 230.

The communication unit 210 may perform functions for transmitting and receiving signals over a wireless channel. For example, the communication unit 210 may perform a conversion function between a baseband signal and a bit string according to a physical layer specification of a system. For example, during data transmission, the communication unit 210 may generate complex symbols by encoding and modulating a transmission bit string. Further, during data reception, the communication unit 210 may restore the received bit string by demodulating and decoding the baseband signal. Further, the communication circuit 210 may up-convert the baseband signal into a radio frequency (RF) band signal to transmit the RF band signal through an antenna, and down-convert an RF band signal received through the antenna into a baseband signal.

To this end, the communication circuit 210 may include a transmission filter, a reception filter, an amplifier, a mixer, an oscillator, a digital-to-analog converter (DAC), an analog-to-digital converter (ADC), or the like. Further, the communication unit 210 may include a plurality of transmission/reception paths. Furthermore, the communication unit 210 may include at least one antenna array including a plurality of antenna elements. In terms of hardware, the communication circuit 210 may include a digital unit and an analog unit, and the analog unit may include a plurality of sub-units depending upon operating power, operating frequency, and the like. In addition, the communication unit 210 may include a decoding unit adapted to perform decoding according to various embodiments of the disclosure.

The communication unit 210 may be configured to transmit and receive signals as described above. Accordingly, the communication unit 210 may be referred to as 'transmitter', 'receiver', or 'transceiver'. Further, in the following description, transmission and reception performed through a wireless channel are used to mean that the above-described processing is performed by the communication circuit 210. Further, when the device of FIG. 2 is a base station, the communication circuit 210 may further include backhaul communication circuitry for communication with another network entity connected through a backhaul network.

The storage unit 220 may store data such as a basic program, an application program, setting information and the like for operating the receiving-end 120. The storage unit 220 may include a volatile memory, a non-volatile memory, or a combination of the volatile memory and the non-volatile memory. Further, the storage unit 220 may provide the stored data according to a request of the controller 230.

The controller 230 may control the overall operations of the device. For example, the controller 230 may transmit and receive signals through the communication unit 210. Further, the controller 230 may write or read data to/from the storage unit 220. To this end, the controller 230 may include at least one processor or a micro-processor, or may be a part of that processor. According to various embodiments, the controller 230 may control the device to perform operations according to various embodiments described below.

In the disclosure, while the embodiments will be described using the terms used in some communication and broadcasting standards (e.g., 3rd Generation Partnership Project, 3GPP), it is only of an example for description, and various embodiments of the disclosure may be easily modified and applied to other communication systems.

Further, in the detailed description of the disclosure, commonly used mathematical symbols may be utilized. Such mathematical symbols may be clearly understood by those skilled in the art to which the disclosure pertains. Typically, the following mathematical symbols are used in the disclosure.

- A calligraphic character (e.g., $\mathcal{A}$) is used to indicate a set.
- Unless otherwise stated throughout the disclosure, it is assumed that an index of a first element of a set, a sequence, or a vector starts from zero (zero-based numbering)

- Symbols (e.g., $\mathbb{N}$, $\mathbb{Z}$, $\mathbb{R}$) are used to indicate a set of natural numbers, a set of integers, and a set of real numbers, respectively.

- A symbol $\mathbb{F}_2$ represents a binary field.

- For a non-negative integer $n$, $\mathbb{Z}_n$ represents a set of consecutive $n$ integers from 0 to ($n$ -1). That is,

$$\mathbb{Z}_n = \{0, 1, \ldots, n - 1\}.$$

- A boldfaced lowercase letter (e.g., a) is used to indicate a vector, and a boldfaced uppercase letter (e.g., A) is used to indicate a matrix. In the case of a vector, it indicates a column vector, unless otherwise stated.

- For a vector **a** and a matrix **A**, $\mathbf{a}^T$ and $\mathbf{A}^T$ represent its respective transpose.

- For the vector **a** and two non-negative integers ($i, j$), $\mathbf{a}_i^j$ represents a sub-vector including consecutive elements from an $i$-th element to a $j$-th ement of the vector **a**. That is, $\mathbf{a}_i^j = (a_i, a_{i+1}, \ldots, a_j)$.

The polar code is the first error correction code, proposed by E. Arikan, that has proved to achieve a channel capacity which is the limit of data transmission performance in binary discrete memoryless channels (B-DMCs), while it has a low level of coding/complexity performance capable of easy implementation[1]. Decoding schemes based on the polar code and the successive cancellation (SC) typically enable excellent error correction performance to be achieved when transmitting a short length of code compared to other channel codes. Because of this advantage, 3GPP New Radio (NR), which is a 5G mobile communication standard, uses the polar code to transmit control information having a short length.

The operating principle of the polar code is basically based on channel polarization. Hereinafter, the channel polarization is introduced based on the contents described in the literature

[1]. For an input alphabet $X$ (a set of values that an input may have) and an output alphabet $Y$ (a set of values that an output may have), a B-DMC channel ($W: X \rightarrow Y$) is a function of transitioning of a channel input $x \in X$ to a channel output $y \in Y$. Here, the input alphabet $X$ is the same as the binary field $\mathbb{F}_2$. For the given channel input $x \in X$ and channel output $y \in Y$, $W(y|x)$ is a transition probability to receive $y$ when transmitting $x$. At this time, it is considered that the transmitter has transmitted a bit vector $\mathbf{x} = (x_0, x_1, \ldots, x_{N-1}) \in X^N$ of a length N, through independent and identical distribution (i.i.d.) B-DMC $W^N$ and the receiver then has received $Y = (y_0, y_1, \ldots, y_{N-1}) \in Y^N$. Here, the length N is a square number of 2, and $N = 2^n$ for an arbitrary natural number $n$. In other words, it is $n = \log_2 N$. In this case, a vector B-DMC of the length N may be defined as $W^N: X^N \rightarrow Y^N$, and since each channel is independent, the transition probability of the vector B-DMC of the length N becomes $W^N(\mathbf{y}|\mathbf{x}) = \prod_{i=0}^{N-1} W(y_i|x_i)$.

The bit vector **x** transmitted in the communication system and the broadcasting system considered in the disclosure is a codeword vector encoded with the polar codes. An encoding input bit vector (encoder input bit vector) is $\mathbf{u} = (u_0, u_1, \ldots, u_{N-1}) \in X^N$ and the transmitter generates an encoding output bit vector (encoder output bit vector) $\mathbf{x} = (x_0, x_1, \ldots, x_{N-1}) \in X^N$ obtained by encoding the same. The encoding output bit vector is also referred to as a codeword vector, and throughout the disclosure these two names will be used with the same meaning depending upon the context. Here, the encoding input bit vector **u** may include at least one parity bit as a result of encoding by outer encoding. The parity bit of the polar code is characterized by being causally generated, and more specifically, the parity bit $u_i$ is determined by a linear combination of bits $\{u_0, u_1, \ldots, u_{i-1}\}$ having a smaller index. Further, the encoding input bit vector **u** may include at least one frozen bit (or a fixed bit) to perform a targeted code expurgation. A value of the frozen bit is determined in advance (i.e., not obtained by encoding and decoding process and its results), and it is usually zero.

The encoding process of the polar code is a process of generating a codeword vector **x** of the same length $N$ by multiplying the encoding input bit vector **u** by a generator matrix $\mathbf{G} \in \mathbb{F}_2^{N \times N}$. Specifically, the codeword vector **x** is generated by Equation 1 below.

<Equation 1>

$$\mathbf{x} = \mathbf{uG}$$

The generation matrix **G** is defined as in Equation 2 in the reference [1] where the first polar code was proposed.

<Equation 2>

$$\mathbf{G} = \mathbf{B}_N \mathbf{F}^{\otimes n}$$

In the Equation 2 above, **F** is called a polarization kernel, and it is $\mathbf{F} = \begin{bmatrix} 1 & 0 \\ 1 & 1 \end{bmatrix}$. The superscript $\otimes n$ operation in the Equation 2 denotes $n$ times of Kronecker power. The Kronecker power may be calculated in a repetitive manner, such as, e.g., $\mathbf{F}^{\otimes 2} = \begin{bmatrix} \mathbf{F} & 0 \\ \mathbf{F} & \mathbf{F} \end{bmatrix}$, $\mathbf{F}^{\otimes 3} = \begin{bmatrix} \mathbf{F}^{\otimes 2} & 0 \\ \mathbf{F}^{\otimes 2} & \mathbf{F}^{\otimes 2} \end{bmatrix}$. And $\mathbf{B}_N$ is an $N \times N$ size of bit-reversal permutation matrix. For example, when a vector $(a_0, a_1, a_2, a_3, a_4, a_5, a_6, a_7)$ of a length of 8 is multiplied by $\mathbf{B}_8$, a vector $(a_0, a_4, a_2, a_6, a_1, a_5, a_3, a_7)$ is generated in which indexes are bit-reversal permutated. Recently, in various related documents and systems, including the 3GPP NR system, the generation matrix of the following equation 3 except for $\mathbf{B}_N$ is considered.

<Equation 3>

$$\mathbf{G} = \mathbf{F}^{\otimes n} = \mathbf{F}^{\otimes \log_2 N}$$

Unless otherwise stated below, it is assumed a generation matrix $\mathbf{G} = \mathbf{F}^{\otimes n}$ defined in the equation 3 above. However, the following contents and the detailed description of the disclosure may be equally applied to a system taking into account the generation matrix $\mathbf{G} = \mathbf{B}_N \mathbf{F}^{\otimes n}$ defined in the equation 2 by performing a simple additional operation (e.g., applying a bit-reversal permutation corresponding to one of an encoding input bit vector or an encoding output bit vector). Whether or not such a bit-reversal permutation is included in the generation matrix does not affect operations, characteristics, and effects according to embodiments of the disclosure.

The encoding output bit sequence **x** generated by the encoding is transmitted through a channel, and the receiver obtains $\mathbf{y} = (y_0, y_1, ..., y_{N-1}) \in Y^N$. Here, unlike the alphabet $X$, the alphabet $Y$ does not necessarily have to be a binary field $\mathbb{F}_2$. In addition to transmission to a channel, various operations such as e.g., rate matching and rate dematching, interleaving and deinterleaving, modulation and demodulation or the like may be performed in the transition from a codeword bit sequence **x** to a receiving vector **y**. For a simple representation, in general, in consideration of all of these operations, an end-to-end vector channel $W^N$ from **x** to **y** is considered.

The goal of the decoder of the receiving device is to accurately estimate an information bit vector **u** from the receiving vector **y**. The method and device for decoding the polar code may use the receiving vector **y** as it is, or may use by converting the receiving vector into a corresponding log likelihood ratio (LLR) vector $\Lambda$. The vector channel from **u** to **y** may be expressed as $W_N: X^N \rightarrow Y^N$ by combining a series of processes of encoding and channel transmission. The channel $W_N$ may be expressed as a vector channel obtained through channel combining.

An SC decoder of the polar code obtains an estimated value $\hat{\mathbf{u}} = (\hat{u}_0, \hat{u}_1, \hat{u}_2, ..., \hat{u}_{N-1})$ by sequentially decoding the encoding input bit vector $\mathbf{u} = (u_0, u_1, ..., u_{N-1})$ one by one in ascending order of the index. That is, the SC decoder sequentially performs decoding on bits in order of $u_0, u_1, u_2, ..., u_{N-1}$. The bits already decoded and estimated may be removed from the receiving vector $y$ or a decoding target corresponding thereto and then used to facilitate decoding of the next bit. Due to such a feature, the corresponding decoding operation may be referred to as a successive cancellation (SC).

The vector channel $W_N$ is channel split into binary-input channels for each bit of **u** by the SC decoding operation. The channel-split binary-input channel may be referred to as a sub-channel, a split channel, a polarized channel, or the like. Hereinafter, in the disclosure, an expression 'sub-channel is used. In the SC decoding, decoding of the $i$-th bit $u_i$ is performed based on an observation result $y$ of a given channel and the previously estimated $\hat{\mathbf{u}}_0^{i-1} = (\hat{u}_0, \hat{u}_1, ..., \hat{u}_{i-1})$. Under the premise that the previously estimated bits are correct (i.e., $\hat{\mathbf{u}}_0^{i-1} = \mathbf{u}_0^{i-1}$), the sub-channel for $u_i$ is written as $W_N^{(i)}: \mathcal{X} \rightarrow \mathcal{Y}^N \times \mathcal{X}^i$, and it is defined as the following equation 4 below in [1].

**<Equation 4>**

$$W_N^{(i)}\left(\mathbf{y}, \mathbf{u}_0^{i-1} \mid u_i\right) \triangleq \frac{1}{2^N - 1} \sum_{\mathbf{u}_{i+1}^{N-1} \in \mathcal{X}^{N-i+1}} W_N(\mathbf{y} \mid \mathbf{u})$$

Through the above-described channel combining and separation process, a sub-channel $W_N^{(i)}$ for $u_i$ is polarized. That is, some of the set $\left\{W_N^{(i)} : i = 0, 1, \ldots, N - 1\right\}$ of the sub-channel may become a good binary-input sub-channel with a channel capacity close to 1, while the others becomes a bad binary-input sub-channel with a channel capacity close to 0. The channel capacity of the sub-channel $u_i$ is determined by the index $i$, and the channel capacity of the sub-channel for each bit is deterministic in designing the polar code. Therefore, the most important operating principle of the polar code system is that information bit is allocated to the index having a high channel capacity in $\mathbf{u}$, and the value is fixed without allocating the information bit to other remaining indexes. The bit to which no information is allocated is referred to as a frozen bit (or a fixed bit), and its value is usually fixed to zero.

The encoding input vector $\mathbf{u}$ for the polar code may include a frozen bit (or a fixed bit), a parity bit, and an information bit. The bits may be referred to as various other names, and this parity bit may be typically referred to as a dynamic frozen bit. Bits other than fixed bits are also called unfrozen bits. The information bit is a bit in which information capable of having a bit value of 0 or a bit value of 1 is carried, and the information bit may be assigned to a sub-channel having a high channel capacity in the polar code. The fixed bit is a bit to which a value is fixed and may be allocated to a sub-channel having a low channel capacity. A value of the fixed bit is usually determined to be zero, but it is not necessarily limited thereto (i.e., the value of the fixed bit may be determined to be 1). This fixed bit is a bit used for channel polarization, and may be interpreted as improving the channel capacity of another sub-channel instead of giving up the amount of information by fixing the bits. The parity bit in the polar code is the same as the fixed bit in that no information is carried, but the value is not fixed to a specific value and is causally generated based on its preceding bits (i.e., bits with a small index). The causally generated parity bit is used to improve error correction performance or error detection performance, by using or checking a result of decoding of the previously decoded and estimated information bits in an SC-based decoding method and device to be described later. According to an embodiment, the parity bit may be a cyclic redundancy check (CRC) bit. Further, according to an embodiment, the parity bit may further include a parity check (PC) bit as defined in 3GPP systems.

Consider an embodiment in which 3-bit information bits $d_0$, $d_1$, $d_2$ are encoded, given using the polar code having a length of 8. In the encoding input bit vector $\mathbf{u} = (u_0, u_1, u_2, u_3, u_4, u_5, u_6, u_7)$, each of the information bits may be assigned to $u_3$, $u_5$, $u_7$ and encoded. The corresponding encoding input bit $u_3$, $u_5$, $u_7$ may be determined by processing $d_0$, $d_1$, $d_2$ by an arbitrary permutation, and in this embodiment, it is assumed that the encoding input bits are mapped in an index order such as e.g., $u_3 = d_0$, $u_5 = d_1$, $u_7 = d_2$. The parity bit is 1 bit, and the parity bit may be assigned to $u_6$. The parity bit may be generated by linearly combining bits having an index smaller than an index (e.g., 6) of the parity bit. In this embodiment, it may be determined as $u_6 = u_3 \oplus u_5 = d_0 \oplus d_1$. Here, the symbol $\oplus$ represents a modulo-2 sum. The remaining bits $u_0, u_1, u_2, u_4$ except for the information bit and the parity bit are fixed bits, and the value may be fixed to zero. Determining which one of the information bit, the parity bit, and the fixed bit is to be applied for each bit of $\mathbf{u}$, as described above, may be referred to as sub-channel allocation, rate profiling, or the like. As a result of the above-described sub-channel allocation, the encoding input bit vector may be determined as $\mathbf{u} = (u_0, u_1, u_2, u_3, u_4, u_5, u_6, u_7) = (0,0,0, d_0,0,d_1, d_0 \oplus d_1,d_2)$.

When representing a code configuration of the polar code, it may be used as a set symbol $\mathcal{A}$, $\mathcal{P}$, $\mathscr{F}$ of a bit index. The symbol $\mathcal{A}$ is used as an index set of encoding input bits to which the information bits are assigned, and it may become $\mathcal{A} = \{3,5,7\}$ in the above example. The symbol $\mathcal{P}$ is used as an index set of encoding input bits to which the parity bits are assigned, and it may become $\mathcal{P} = \{6\}$ in the above example. The symbol $\mathscr{F}$ is used as an index set of encoding input bits to which the fixed bits are assigned, and it may become $\mathscr{F} = \{0,1,2,4\}$ in the above example.

The equation 4 for channel polarization is too complicated to calculate as it is, so it may be practically impossible to operate. The number of additions required to decode one $i$-th bit $u_i$ may become approximately the size of a set $X^{N-i+1}$. For example, if $N$ is 64 and $i$ is 5, then the size $|X^{N-i+1}|$ of the set $X^{N-i+1}$ becomes $2^{60} \approx 1.15 \times 10^{18}$. It is not of a level that can be normally processed no matter how good hardware and excellent algorithms are used.

For a realistic SC decoding, the reference [1] shows that the transition probability defined in the equation 4 or an LLR corresponding thereto may be calculated using a simple recursion operation. This recursive operation is possible because the generation matrix $\mathbf{G}$ used for encoding of the polar code, as in the equation 2 and the equation 3 above, is configured repeatedly and regularly from a small matrix $\mathbf{F}$. A conventional SC-based decoding method and device does not calculate a transition probability $W_N^{(i)}\left(\mathbf{y}, \mathbf{u}_0^{i-1} \mid u_i\right)$ or a value corresponding to the transition probability as the operation described in the equation 4. The conventional SC-based decoding method and device calculate it using a simple recursion operation based on a structure of the generation matrix. In this case, the amount of operations (the number of additions and operations corresponding thereto) required to perform the SC decoding is $O(N \log N)$, which is suitable for implementation.

An embodiment of an operation of SC decoding for a conventional polar code will be described below. In this conventional embodiment, the SC decoding using an LLR is considered. However, the contents of embodiments of the disclosure are not limited to an LLR-based polar code decoding method and device, and may be applied to any type of SC-based decoding method and device.

First, an input LLR sequence $\Lambda = (\lambda_0, \lambda_1, ..., \lambda_{N-1})$ of length $N$ is given for decoding the polar code. The SC-based decoding method and device are characterized in that each bit of an encoding input bit vector **u** is sequentially decoded by one bit according to an index order. Decoding is performed on each bit in ascending order of indexes of the encoder input bit sequence, that is, in order of $u_0, u_1, ..., u_{N-1}$. Specifically, the SC-based decoding method and device operate as follows.

The decoding bit index $i$ is initially set to zero.

If $u_i$ is an information bit, a calculation is made of an LLR which is a probability-based metric for 0 and 1 of $u_i$, based on an input LLR sequence and estimated values $\hat{u}_0, \hat{u}_1, ..., \hat{u}_{i-1}$ of the previously decoded bits. Based on these values, an estimation $\hat{u}_i$ of $u_i$ is determined.

If $u_i$ is a fixed bit or a parity bit other than an information bit, the estimation $\hat{u}_i$ of $u_i$ may be determined by the corresponding scheme.

For decoding of the next bits, the estimation $\hat{u}_i$ is reflected in the decoder based on the successive cancellation (SC).

The process ② is performed by incrementing the decoding bit index $i$ by 1. If the decoding bit index $i$ becomes N, the decoding is terminated.

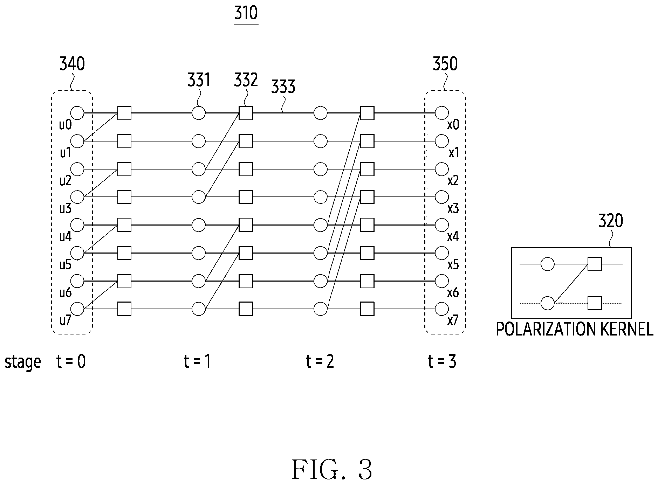

The encoding process and the decoding process of the polar codes may be understood and implemented based on belief-propagation on a bipartite graph corresponding to the generation matrix of FIG. 3.

FIG. 3 illustrates an example of a graph corresponding to a polar code in a communication system or a broadcasting system according to embodiments of the disclosure.

Referring to FIG. 3, FIG. 3 illustrates an example of a binary graph 310 for a generation matrix $\mathbf{G} = \mathbf{F}^{\otimes 3}$ of a polar code having a size of 8. The binary graph includes variable nodes 331 indicated by a circle, check nodes 332 indicated by a square, and connection lines (edges) 333 connecting those nodes. The variable node represents a respective bit, and the check node represents a linear constraint for the bits of a connected neighboring variable node. Specifically, the check node indicates that the modulo-2 sum of all bits corresponding to the neighboring variable node is 0.

In the bipartite graph of the polar code, a connection between the variable node and the check node is determined by the generation matrix **G** configuration. As shown in the equation 2 and the equation 3, the generation matrix **G** is generated with the Kronecker power of the polarization kernel **F,** and thus the entire bipartite graph 310 has a form in which the graph of the polarization kernel 320 are repeatedly and regularly connected. Describing more specifically, the

$$\mathbf{F} = \begin{bmatrix} 1 & 0 \\ 1 & 1 \end{bmatrix}$$

polarization kernel 320 describes a relationship of linear transformation for the input size of 2 and the output size of 2, and it represents a Z-shaped form. Since the generation matrix **G** is made with a successive Kronecker power of **F,** the polarization kernel 320 of the entire binary graph 310 is configured of a regular arrangement of a Z-shaped graph, as illustrated in FIG. 3.

The graph of the polar code of a length N configured as described above includes $n + 1$ stages. When a symbol $t$ is used as a stage index of the graph, the stage index for the leftmost variable nodes of the graph is indicated as $t = 0$ and the stage index for the rightmost variable nodes of the graph is indicated as $t = n$. Among them, the N variable nodes 340 in the leftmost step ($t = 0$) correspond to the encoding input bit vector **u**, and the variable nodes 350 in the rightmost step ($t = n$) correspond to the encoding output bit vector **x**.

The encoding process of the polar code by multiplication of the generation matrix **G** shown in the equation 1 may be understood on the graph of FIG. 3. The encoding input bit vector **u** is assigned given to N variable nodes 340 in the leftmost step ($t = 0$) on the graph of FIG. 3. Then, in ascending order of the step index $t$ (from left to right), bit values of the variable nodes are determined to satisfy a relational expression of the check nodes. In other words, the encoding process may be understood as an operation of sequentially updating the bit values according to the relationship between the variable nodes and the check nodes, from the left to the right of the graph shown in FIG. 3. The encoding by multiplication of the generation matrix of the equation 1 may be implemented and realized by any methods, and the method using the graph may also generates the same result of encoding.

The SC-based decoding of the polar code may also be understood as a belief-propagation operation on the graph of FIG. 3. As a first step of decoding, the LLR given for the codeword bit vector **x** (the receiving vector **y** upon receiving) is caused to correspond to or input to the N variable nodes 350 in the rightmost step ($t = n$) of the graph. Then, through a series of operations, a-posteriori LLR (AP-LLR) of the encoding input bit vector **u** corresponding to the variable node of the leftmost step ($t = o$) of the graph is sequentially calculated one by one. The AP-LLR of each bit is obtained by sequentially calculating and updating the LLR of the variable node for each step, from the right side to the left side of the graph (i.e., in descending order of the step index). That is, the initial LLR is given to the step ($t = n$), from which the LLR values for some variable nodes of each step are calculated in the order of $t = n - 1, n - 2, ....$ Through this process, the AP-LLR value for the variable node of the step ($t = o$) is calculated.

The detailed LLR calculation process on the polar code graph is as follows. As described above, in the entire bipartite graph, a Z-shaped polarization kernel 320 of the polarization kernel is configured as a basic element, and calculation of all log-likelihood ratio (LR) values is carried out on such a basic element.

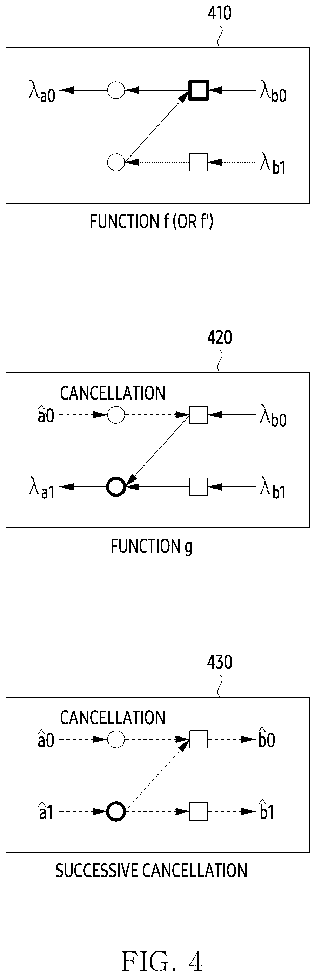

FIG. 4 illustrates an basic element process of performing a log-likelihood ratio (LLR) operation and a successive cancellation in a polar code decoding method and device of a communication system or a broadcasting system, according to an embodiment of the disclosure.

Referring to FIG. 4, an example of an LLR calculation process on the basic element is illustrated. In this Z-shaped basic element graph, a bit vector corresponding to the left two variable nodes is taken as **a** = ($a_0$, $a_1$) and a bit vector corresponding to the right two variable nodes is taken as **b** = ($b_0$, $b_1$). The relationship between **a** and **b** by a polarization kernel **F** is expressed by the equation as follows.

<Equation 5>

$$\mathbf{b} = \mathbf{aF} = \mathbf{a} \begin{bmatrix} 1 & 0 \\ 1 & 1 \end{bmatrix}$$

Let us write the LLR values corresponding to bits $a_0$, $a_1$, $b_0$, $b_1$ as $\lambda_{a0}$, $\lambda_{a1}$, $\lambda_{b0}$, $\lambda_{b1}$, respectively. In decoding for each basic element, the values $\lambda_{b0}$, $\lambda_{b1}$ corresponding to the right two variable nodes are given, and one of the LLR values $\lambda_{a0}$ and $\lambda_{a1}$ is calculated by the decoding process. According to a sequential decoding method of the aforementioned polar code, the LLR value of $a_0$ is calculated and estimated, based on which the LLR value of $a_1$ is then calculated and estimated. First, $\lambda_{a0}$ may be calculated using a function $f$(410) of FIG. 4.

<Equation 6>

$$\lambda_{a_0} = f\left(\lambda_{b_0}, \lambda_{b_1}\right) = 2 \tanh^{-1}\left(\tanh\left(\lambda_{b_0}/2\right)\tanh\left(\lambda_{b_1}/2\right)\right)$$

The equation 6 represents a method of accurately calculating an LLR value according to a relationship between bits, which may be obtained being approximated by a function $f'$ as in the following equation for simpler calculation and implementation.

<Equation 7>

$$\lambda_{a_0} = f'\left(\lambda_{b_0}, \lambda_{b_1}\right) = \text{sgn}\left(\lambda_{b_0}\right)\text{sgn}\left(\lambda_{b_1}\right)\min\left(\left|\lambda_{b_0}\right|, \left|\lambda_{b_1}\right|\right)$$

In the above equation, the function sgn($\cdot$) indicates a function that returns a sign of an input value, and it may output '1' when the input value is greater than 0 and '-1' when the input value is less than 0.

When the estimation $\hat{a}_0$ of the bit $a_0$ is obtained or available as the decoding progresses, $\lambda_{a1}$ is calculated through a function $g$ (420) of FIG. 4.

<Equation 8>

$$\lambda_{a_1} = g\left(\lambda_{b_0}, \lambda_{b_1}, \hat{a}_0\right) = (-1)^{\hat{a}_0}\lambda_{b_0} + \lambda_{b_1}$$

As described above, in the SC-based decoding method and device, bits are sequentially decoded and estimated according to the bit indices. Therefore, decoding and estimation for $a_1$ are necessarily performed after checking or estimating the value of $a_0$.

The calculation process of the LLR described with reference to FIG. 4 as above is directed to a basic element of the polarization kernel, and this basic element may be connected with another variable node and check node as a part of the entire graph. When the basic element is not located in the leftmost step ($t = o$), the calculated $\lambda_{a_0}$ and $\lambda_{a_1}$ are transferred to other Z-shaped basic elements connected to the left (i.e., where the step index t is smaller by 1). And the corresponding steps are performed in the same manner also in the transferred basic element. In this way, the decoding is performed in descending order (i.e., in decreasing order of $t$) of the step index from the step ($t = n$). When the LLR value of the encoding input bit of the variable node on the leftmost side (step $t = 0$) of the graph is obtained, the bit value is estimated based on the LLR value. If the corresponding bit is a fixed bit, then a predetermined value (e.g., 0) may be substituted regardless of the calculated LLR value. If the corresponding bit is a parity bit, then the value may be determined based on the previously estimated or determined bit. If the corresponding bit is an information bit, then a result of hard-decision of an updated LLR value may be substituted into the corresponding bit. When the AP-LLR finally calculated for the encoding input bit $u_i$ is written as $\lambda^{(i)}$, the decoder determines estimation $\hat{u}_i$ based on this value. For example, if the LLR is defined such that a positive number corresponds to bit 0 and a negative number corresponds to bit 1, the estimation $\hat{u}_i$ is determined as shown in the following equation.

<Equation 9>

$$\hat{u}_i = \begin{cases} 0, & \text{if } \lambda^{(i)} > 0 \\ 1, & \text{otherwise} \end{cases}$$

In the case of a floating-point operation, if the LLR value is 0, a bit value is determined by a predetermined rule. A method of the predetermined rule may be a random decision.

The bits estimated as a result of decoding may be transferred from the left to the right of the graph to the variable nodes in the range available in the current decoding step, and may be used for an LLR calculation of other variable nodes as in the equation 8. This process may be understood as a successive cancellation operation to reflect and cancel a result of decoding so far from the receiving vector or LLR to be decoded, so as to facilitate decoding of the next bit. This successive cancellation process may also be understood in a Z-shaped basic element such as the function $g$ (420) and the SC (430) of FIG. 4. When decoding is performed and estimation $\hat{a}_0$ of $\hat{a}_0$ is then obtained, it is reflected into the graph as in the function $g$ (420) described above to enable calculation of $\lambda_{a_1}$ through the equation 8. When the decoding is performed and the estimation $\hat{a}_0$, $\hat{a}_1$ of $a_0$, $a_1$ is obtained, it is reflected into the graph as shown in the SC 430 to enable calculation of $\hat{b}_0$, $\hat{b}_1$ which is the estimation of $b_0$, $b_1$. Specifically, it is determined as $\hat{b}_0 = \hat{a}_0 \oplus \hat{a}_1$, $\hat{b}_1 = \hat{a}_1$ according to the relationship of the polarization kernel. As such, when a bit corresponding to the right variable node of the basic element is estimated, this value is transferred back to other Z-shaped basic elements connected to the right side of the graph (i.e., the side with the step index t larger by 1). According to the decoding procedure and process, bits of the encoding input bit vector u are decoded one by one in ascending order of the indexes. A process of sequentially estimating and determining bits in the SC-based decoding process may be understood based on a binary decision tree.

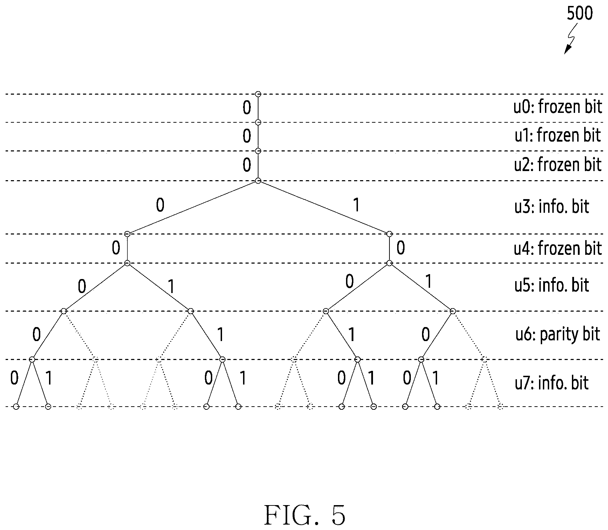

FIG. 5 illustrates an example of a binary decision tree for sequentially decoding and estimating bits in a polar code decoding method and device of a communication system or a broadcasting system according to embodiments of the disclosure.

Referring to FIG. 5, an example of a binary decision tree 500 for a process of sequentially estimating and determining an encoding input bit of a polar code having a size of 8 is illustrated in FIG. 5. In this embodiment, the above-described sub-channel allocation is used, wherein specifically in the encoding input bit vector $\mathbf{u} = (u_0, u_1, u_2, u_3, u_4, u_5, u_6, u_7)$, $u_0$, $u_1$, $u_2$, $u_4$ are fixed bits, $u_3$, $u_5$, $u_7$ are information bits, and $u_6$ is a parity bit generated by $u_6 = u_3 \oplus u_5$.

The SC-based decoding method and device decode bits of **u** in ascending order of an index. First, $u_0$ is immediately determined as a fixed bit, and the estimation $\hat{u}_0$ as 0. Therefore, as shown in FIG. 5, no branching occurs for a value of $u_0$. Likewise, $u_1$ and $u_2$ are also a fixed bit, and both the estimations $\hat{u}_1$ and $\hat{u}_2$ are determined to be zero. The bit $u_3$ is an information bit, and the estimation $\hat{u}_3$ is determined to be one of '0' or '1', based on the LLR calculated through the series of processes. Accordingly, branching occurs in the binary decision tree. In the same way, the fixed bit $u_4$ and the information bit $u_5$ are decoded and an estimation for them is obtained. The parity bit $u_6$ may be processed and decoded in two ways. First, according to $u_6 = u_3 \oplus u_5$, the estimation on $u_6$ may be determined by $\hat{u}_6 = \hat{u}_3 \oplus \hat{u}_5$ based on the previously estimated values. Secondly, the LLR on $\hat{u}_6$ may be calculated through the series of fixings, and $\hat{u}_6$ may be obtained by its hard-decision. This estimation $\hat{u}_6$ may be compared with $\hat{u}_3 \oplus \hat{u}_5$ as to whether they are the same, based on the previously decoded result. If the two results are different, the decoding result violates a given constraint, so the decoder may determine that the decoding result so far is wrong. Based on the comparison information, the decoder may perform a follow-up operation suitable for a decoding algorithm in use, such as e.g., pruning an invalid path or early termination of decoding. In the binary decision tree of FIG. 5, only determination path of valid $u_6$ according to the previously decoded values of $u_3$ and $u_5$ are represented. For example, if $u_3 = 0$ and $u_5 = 0$, then it cannot be $u_6 = 1$, so the determination path for it is excluded.

The above process is related to an SC decoding method and device, which process may be used through some modifications in various variations such e.g., as SCL decoding, SCS decoding, and SCF decoding.

Specific embodiments of the disclosure will now be described to identify and overcome limitations of conventional SC-based decoding methods and devices.

The transition probability calculated by the conventional SC-based decoding methods and devices is consequently based on the equation 4. In other words, when operations used in repetitive operations of the SC-based decoding method and device are not approximated, its finally calculated value is substantially the same as the value calculated by the equation 4. In the case of an LLR-based decoding method and device, if an AP-LLR calculated for an encoding input bit $u_i$ is written as $\lambda^{(i)}$ as in the equation 9, this value is the same as the following equation based on the equation 4.

<Equation 10>

$$\lambda^{(i)} = \log \frac{W_N^{(i)}\left(\mathbf{y}, \mathbf{u}_0^{i-1} \mid u_i = 0\right)}{W_N^{(i)}\left(\mathbf{y}, \mathbf{u}_0^{i-1} \mid u_i = 1\right)}$$

Here, it is used the definition indicating that a positive number of the LLR value stands for bit 0 and a negative number thereof stands for bit 1. Even if this definition is the opposite, it may be understood and implemented by changing the codes of LLRs generated and calculated by the decoding method and device.

Referring to the right-hand side of the equation 4, which is the basis of the conventional SC-based decoding method and device, the transition probability of the sub-channel on $u_i$ is a result of marginalization for all values (i.e., $X^{N-i+1}$)

capable of having all subsequent bits $\mathbf{u}_{i+1}^{N-1} = \left(u_{i+1}, u_{i+2}, \ldots, u_{N-1}\right)$. However, in the configuration of the polar code, a value-constrained bit such as a fixed bit or a parity bit may exist in $\mathbf{u}_{i+1}^{N-1}$. The presence of such constrained bits shows that the transition probability of the sub-channel of the equation 4 is defined and is not accurate considering the actual configuration of the polar code.

In other words, the transition probability and the LLR calculated for $u_i$ in the conventional SC-based decoding method and device do not take into account a configuration of $\mathbf{u}_{i+1}^{N-1} = \left(u_{i+1}, u_{i+2}, \ldots, u_{N-1}\right)$ to be decoded later than $u_i$. In the calculation method of the LLR, all the bits decoded later than $u_i$ are treated as pure noise. Despite this relaxation, as proved in the reference [1], the polar code may achieve the channel capacity as its length increases. However, since such relaxation does not take into account constraints on bit values, it reveals that a conventional practical SC-based decoding and device for the polar code of a finite length are not optimal. Hereinafter, the above contents will be visually described through some examples.

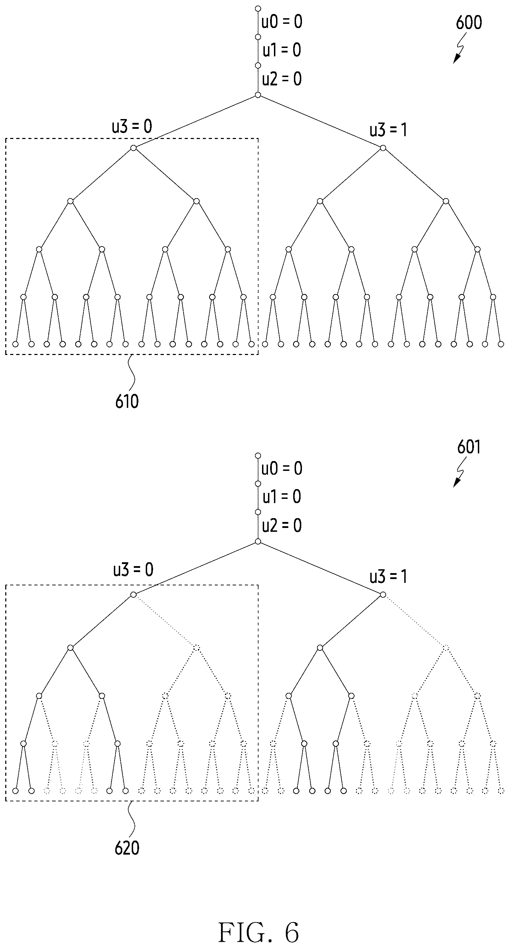

FIG. 6 illustrates an example of a binary decision tree considered in a polar code decoding method and device of a communication system or a broadcasting system according to embodiments of the disclosure.

Referring to FIG. 6, a binary decision tree 600 illustrates an example of a binary decision tree considered in a conventional SC-based decoding method and device, when performing decoding for an information bit $u_3$ in the embodiment described with reference to FIG. 5. In the conventional method and device, it is assumed that all the bits of

$\mathbf{u}_4^7 = \left(u_4, u_5, u_6, u_7\right)$ are not constrained in decoding of $u_3$. A sub-tree 610 of the binary decision tree 600 of FIG. 6 includes paths for all 16 combinations that 4 bits of $\mathbf{u}_4^7$ can take. However, considering the configuration of the polar code,

$u_4$ is a fixed bit and $u_6$ is a parity bit, and therefore the number of actually possible combinations that $\mathbf{u}_4^7$ can take for each value $u_3$ is less than 16 combinations. The binary decision tree 601 represents an example of a binary decision tree derived based on possible combinations, when performing decoding for the information bit $u_3$. As shown in the sub-tree 620 of the binary decision tree 601, the number of possible combinations is only four. Accordingly, the binary decision tree 600 envisaged in the conventional method and device is different from the binary decision tree 601 according to a configuration of the actual code, which shows sub-optimality of the conventional decoding method and device.

The decoder according to the embodiments of the disclosure to address the above-described problem may perform the decoding by accurately modifying $W_N^{(i)}\left(\mathbf{y}, \mathbf{u}_0^{i-1} \mid u_i\right)$ of the conventional equation 4 as seen in the

following equation $\acute{W}_N^{(i)}\left(\mathbf{y}, \mathbf{u}_0^{i-1} \mid u_i\right)$.

<Equation 11>

$$\hat{W}_N^{(i)}\left(\mathbf{y}, \mathbf{u}_0^{i-1} \mid u_i\right) \triangleq \frac{1}{2^N - 1} \sum_{\mathbf{u}_{i+1}^{N-1} \in \mathcal{U}_{i+1}^{N-1}\left(\mathbf{u}_0^i\right)} W_N(\mathbf{y} \mid \mathbf{u})$$

In the equation 11 above, $\mathcal{U}_{i+1}^{N-1}\left(\mathbf{u}_0^i\right)$ is a set of all possible combinations of $\mathbf{u}_{i+1}^{N-1}$, when the previously decoded $\mathbf{u}_0^{i-1}$ and the $u_i$ under consideration as a condition (that is, $\mathbf{u}_0^i$ put together) are given. For example, if $u_3$ is decoded in the example addressed in FIG. 5, then $\mathcal{U}_4^7(\mathbf{u}_0^3)$ is as shown in the sub-tree 620 of FIG. 6, specifically as in the equation below.

<Equation 12>

$$\mathcal{U}_4^7(\mathbf{u}_0^3) = \{(0,0,u_3 \oplus 0,0),(0,1,u_3 \oplus 1,0),(0,0,u_3 \oplus 0,1),(0,1,u_3 \oplus 1,1)\}$$

As shown in the equation 11 above, the transition probability accurately considering a code configuration is used in the embodiments of the present disclosure. An LLR-based SC decoding according to embodiments of the disclosure, and a modified method and device thereof calculate an LLR defined as in the equation below.

<Equation 13>

$$\hat{\lambda}^{(i)} = \log \frac{\hat{W}_N^{(i)}\left(\mathbf{y}, \mathbf{u}_0^{i-1} \mid u_i = 0\right)}{\hat{W}_N^{(i)}\left(\mathbf{y}, \mathbf{u}_0^{i-1} \mid u_i = 1\right)}$$

The decoder according to another embodiment may use the LLR defined by exchanging the numerator and the denominator in the equation 13. The scheme using Equation 13 may be understood, implemented and realized as inverting the code of the LLR.

An embodiment of the SC-based decoding method and device of the disclosure is based on the equation 11 in which a marginalization set based on an actual code configuration is set, unlike the conventional decoding method and device. In this context, the SC-based decoding method and device of the disclosure may be referred to as bitwise maximum likelihood - successive cancellation (bitwise ML-SC) decoding. In other words, in the above-described embodiment of the disclosure, the decoder may sequentially decode bits one by one based on successive cancellation. The decoder may perform ML decoding to accurately reflect the code configuration for each bit.

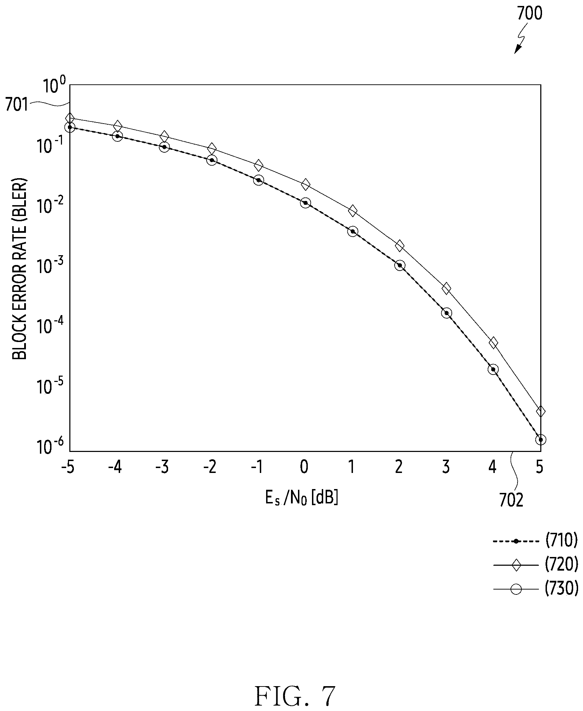

FIG. 7 illustrates the performance of a decoding technique according to embodiments of the disclosure. In FIG. 7 is illustrated the performance of three decoding techniques for the example (a pole code having a length of 8 including three information bits, one parity bit, and four fixed bits) dealt with in FIG. 5.

Referring to FIG. 7, a graph 700 shows the performance of a decoding technique according to embodiments of the disclosure. A vertical axis 701 represents a block error rate (BLER), and a horizontal axis 702 represents a signal-to-noise ratio (SNR). A first line 710 represents the performance according to a Blockwise ML technique. A second line 720 shows the performance according to the SC decoding technique. A third line 730 represents the performance according to a Bitwise ML-SC technique.

The "SC" decoding is a conventional method based on the equation 4. The "Bitwise ML-SC" decoding is a method realized/implemented/operated based on the equation 11 according to an embodiment of the disclosure. In addition, the "Blockwise ML" decoding, which is an optimal decoding method for linear codes such as polar codes, was also considered. The Blockwise ML method is an exhaustive search method that compares a given receiving vector with all valid codeword vectors and selects the most probabilistically feasible one. The codeword vector generated in this experiment is modulated in binary phase shift keying (BPSK) and transmitted through an adaptive white Gaussian noise (AWGN) channel. Under such an environment, the graph 700 may provide a result of a block error rate (BLER) by comparing a decoding result with an encoding input bit vector when each of the three methods is used. $E_s/N_o$ is a parameter representing an SNR and is used as a quantitative metric of channel quality.

As shown in FIG. 7, the conventional SC decoding scheme has lower performance than the optimal Blockwise ML decoding due to sub-optimality in the equation 4. Such low performance implies that more block errors occur due to higher BLER in the same $E_s/N_o$. In addition, such low performance denotes that higher signal strength, that is, $E_s/N_o$ is required to achieve the same block error rate. On the other hand, the Bitwise ML-SC decoding according to an embodiment of the disclosure based on the equation 11 provides the same performance as the Blockwise ML decoding, which is optimal for a block unit, in the corresponding example. From the foregoing, the non-optimality of the conventional method and the optimality of the disclosed invention may be experimentally confirmed.

Now, a method for effectively implementing the SC decoding method and device based on the equation 11 will be described. As described above, calculating the equation 4 as it is may involve a lot of operations. The reference [1] shows that the equation 4 may be implemented with low complexity through recursive operations on polarization kernels, based on the structure of the generation matrix. In the same way, calculating the equation 11 as it is may also require a lot of operations, and the present disclosure includes a method of effectively realizing, implementing and operating the aforementioned process.

In an embodiment of the disclosure, a successive cancellation check (SCC) decoding is used to realistically calculate a transition probability, an LLR and so on corresponding to the equation 11. In the conventional SC-based decoding method and device, upon decoding of an information bit $u_i$ (i.e., i $\in$ $\mathcal{A}$), a decoder calculates a metric such as the transition probability or the LLR and obtains estimation $\hat{u}_i$ of $u_i$. In an embodiment of the disclosure, first, upon decoding of an information bit $u_i$, this value may be substituted or assumed into 0 or 1, respectively. Then, the decoder may calculate a metric of the transition probability, the LLR or the like for at least one bit $u_j$ (i.e., $j > i$) of the bits located behind $u_i$, and then the decoder may check or evaluate a validity of the substitution or assumption. The decoder may determine estimation $\hat{u}_i$ based on the check or evaluation.

In other words, the SCC decoding method and device of the disclosure may determine an estimation value of at least one information bit ($u_i$), after processing the bit ($j > i$) located behind $u_i$ by a series of processes. In particular, $u_j$ may be a fixed bit or a parity bit. The fixed bit or the parity bit having an index greater than a bit to be decoded may be referred to as a future constraint, a future constrained bit, a post-constraint, a post-constrained bit, or the like. The future constraint bit considered for estimation of the $u_i$ may be one bit or at least two bits.

An embodiment of the SCC decoding may include the following series of processes.

Upon decoding the information bit $u_i$ (i.e., i $\in$ $\mathcal{A}$), the decoder selects a target bit index $j$. Here, $j$ is selected as an integer greater than or equal to $i$. For example, $j$ may be selected as the smallest integer that meets both $j \geq i$ and $j + 1 \in \mathcal{A}$. That is, $j$ may be a bit immediately before a next information bit. In this case, since $\mathbf{u}_{i+1}^{j}$ are all fixed bits or parity bits causally generated, the value may be determined immediately if preceding bits $\mathbf{u}_0^i$ are given according to the definition.

It is assumed that the value $u_i$ to be decoded is 0 or 1, respectively. The decoder determines $\mathbf{u}_{i+1}^{j}$ based on the previously decoded $\mathbf{u}_0^{i-1}$ and the above assumed $u_i$. As a result, the decoder checks the entire $\mathbf{u}_0^{j}$ for each hypothesis.

A symbol $\mathcal{H}_0$ denotes hypothesis in which $\mathbf{u}_i^{j}$ (or $\mathbf{u}_0^{j}$) is determined based on the assumption $u_i = 0$.

A symbol $\mathcal{H}_1$ denotes hypothesis in which $\mathbf{u}_i^{j}$ (or $\mathbf{u}_0^{j}$) is determined based on the assumption $u_i = 1$.

The decoder performs decoding on $u_j$ based on the respective hypothesis $\mathcal{H}_0$ and $\mathcal{H}_1$. In an embodiment of this decoding process, the decoder may calculate a probability-based metric on $u_j$ for each hypothesis to select at least one hypothesis based on the calculated probability-based metric. In another embodiment, the decoder may select at least one hypothesis by calculating a probability-based metric on $\mathbf{u}_i^{j}$ for each hypothesis. In still another embodiment, the decoder may select at least one hypothesis by calculating a probability-based metric on $\mathbf{u}_0^{j}$ for each hypothesis. In still another embodiment, the decoder may examine and check the validity on $u_j$ of each hypothesis and select at least one hypothesis based thereon. In still another embodiment, the decoder may check and examine the validity on $\mathbf{u}_i^{j}$ of each hypothesis and select at least one hypothesis based thereon. In still another embodiment, the decoder may check and examine the validity on $\mathbf{u}_0^{j}$ of each hypothesis and select at least one hypothesis based thereon.

As described above, the principles of the disclosure may be realized and implemented in various ways. An important point in embodiments of the present disclosure is that the determination and judgement of the estimation on at least one information bit $u_i$ may be performed after processing at least one other bit located behind the $u_i$. According to an embodiment, the decoder using the polar codes may perform estimation of an information bit corresponding to a specific bit index, after a marginalization using a frozen bit or a parity bit located behind the specific bit index.

The SCC decoding method may be extended and applied to SCL decoding, SCS decoding, or the like, which is a modified method of a conventional SC decoding. In other words, the concept of the SCC decoding method may be also applied to a method of considering two or more candidate groups, other than leaving only one candidate group in the successive decoding and bit decision process. For example, in the decision process of each bit, the concept of SCC decoding may be applied to SCL decoding which maintains a group of up to 7 temporary candidates referred to as a list. The technique in which the SCC decoding is applied to the SCL decoding may be referred to as SCC-list (SCCL) decoding.

When decoding the information bit $u_i$ in the SCL decoding, $L$ lists $\mathbf{u}_0^i[0], \mathbf{u}_0^i[1], \dots, \mathbf{u}_0^i[L-1]$ for the decoding result of the preceding bit may be given. A total number of $2L$ candidate groups of $\mathbf{u}_{i+1}^j$ may be determined by a combination of $L$ lists and an assumption for a $u_i$ value 0, 1. Specifically, for $\ell \in \{0, 1, \dots, L-1\}$ and $B \in \{0, 1\}$, $(2\ell + B)$-th candidate group may be determined based on $\mathbf{u}_0^i[\ell]$ and $u_i = B$. This candidate group may include $\mathbf{u}_{i+1}^j$ determined based on $\mathbf{u}_0^i[\ell]$ and $u_i = B$. The decoder may perform the SCC decoding based on the candidate group. That is, even in decoding for each list, a bit estimation of $u_i$ may be determined during or after processing of $u_j$, wherein $j > i$. In this case, a path metric (PM) and so on, used in the conventional SCL decoding, may be utilized. As a result of the decoding, L candidate groups may be selected from among a total number of $2L$ candidate groups, and a subsequent process may be performed. In the same manner, the SCC decoding method may be extended and applied to SCS decoding, wherein it may be implemented and realized with SCCS decoding.

The SCC decoding method and procedures partially support the concept of the equation 11.

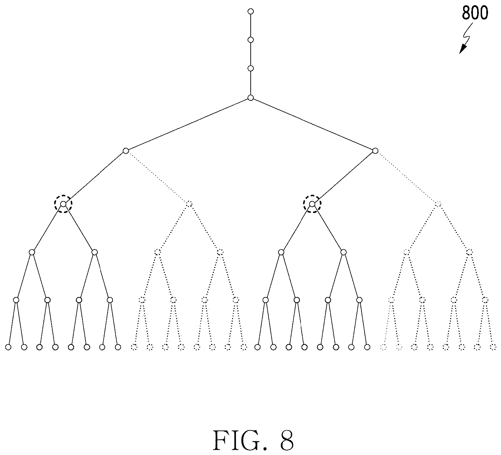

FIG. 8 illustrates an example of a binary decision tree used in a polar code decoding method and device of a communication system or a broadcasting system according to embodiments of the disclosure.

Referring to FIG. 8, a binary decision tree 800 illustrates an example of a binary decision tree envisaged by an SCC decoding method and device in the running example as above. The decoder may perform an estimation of an information bit $u_3$ in a future constraint bit $u_4$ preceding a next information bit $u_5$ according to the SCC decoding method. In this case, the estimation of $u_3$ is carried out after a correct value of the fixed bit $u_4$ is reflected in the decoding. In this way, the SCC decoding method and device are characterized in that upon decoding and estimating of the information bit, some future constraint bits close thereto are reflected. This is a feature of an embodiment of the disclosure that is distinguished from the conventional SC-based decoding method and device.

In another embodiment of the disclosure, belief-propagation successive-cancellation (BP-SC) decoding may be used to realistically calculate a transition probability, an LLR and so on corresponding to the equation 11. The BP-SC decoding method and device may modify the polar code graph introduced in FIG. 3 based on future constraint and use the same. The decoding method and device using polar codes according to embodiments of the disclosure may use the future constraint that has not been considered in the conventional SC-based decoding method and device.

The process of reflecting the future constraint in the bipartite-graph used in the decoding is as follows. The constraint by the fixed bit and the parity bit of the encoding input bit vector $\mathbf{u} \in \mathbb{F}_2^N$ may have a parity-check matrix $\mathbf{H} \in \mathbb{F}_2^{N \times N}$ and may be expressed by the following equation.

<Equation 14>

$$\mathbf{u}\mathbf{H} = 0$$

A k-th column of the parity check matrix $\mathbf{H}$ is represented as $[\mathbf{H}]_k$. In this case, each column of the parity check matrix $\mathbf{H}$ is configured as follows, according to the configuration of the bits of the encoding input bit vector $\mathbf{u}$.

If $u_k$ is an information bit, all elements of the k-th column of the parity check matrix $\mathbf{H}$ are configured as 0. That is, the column vector $[\mathbf{H}]_k$ is a 0 vector.

If $u_k$ is a frozen bit (or a fixed bit), only the element in the k-th row of in the $k$-th column of the parity check matrix $\mathbf{H}$ has a value of 1 and all other elements are configured as 0. The column vector $[\mathbf{H}]_k$ is a vector in which only the elements in the k-th row are 1, and the remaining elements are 0. For example, the column vector $[\mathbf{H}]_k$ of the parity check matrix by the fixed bit $u_4$ is given as $[\mathbf{H}]_4 = (0,0,0,0,1,0,0,0)^T$ in the pole code example ( $\mathcal{A} = \{3,5,7\}$, $\mathcal{P} = \{6\}$, $\mathcal{F} = \{0,1,2,4\}$) of the length $N = 8$ that we are continuously looking into.

If $u_k$ is a causally generated parity bit, the k-th column of the parity check matrix $\mathbf{H}$ is configured to correspond to a parity check equation. For example, if the parity bit $u_6$ is generated by the relational expression of $u_3 \oplus u_5 \oplus u_6 = 0$ in the polar code example ( $\mathcal{A} = \{3,5,7\}$, $\mathcal{P} = \{6\}$, $\mathcal{F} = \{0,1,2,4\}$) of the length $N = 8$ that we are continuously looking into, the column vector is given as $[\mathbf{H}]_6 = (0,0,0,1,0,1,1,0)^T$.

As described above, if the configuration of the polar code (a method of generating the encoding input bit vector **u**) is given, the decoder may identify or determine the configuration of the parity check matrix **H**.

For example, the parity check matrix **H** for the encoding input bit vector **u** in the polar code example ( $\mathcal{A} = \{3,5,7\}$, $\mathcal{P} = \{6\}$, $\mathcal{F} = \{0,1,2,4,\}$) of the continuous length $N = 8$ may be given by the above rule as follows.

<Equation 15>

$$\mathbf{H} = \begin{bmatrix} 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ 0 & 0 & 0 & 0 & 0 & 0 & 1 & 0 \\ 0 & 0 & 0 & 1 & 0 & 0 & 0 & 0 \\ 0 & 0 & 0 & 0 & 0 & 0 & 1 & 0 \\ 0 & 0 & 0 & 0 & 0 & 0 & 1 & 0 \\ 0 & 0 & 0 & 0 & 0 & 0 & 0 & 0 \end{bmatrix}$$

The generation matrix **G** given in the equation 2 and the equation 3 is a self-inverse matrix or an involutory matrix. In other words, it has a relationship of $\mathbf{G}^{-1} = \mathbf{G}$. Accordingly, the equation 1 may be represented as the following equation.

<Equation 16>

$$\mathbf{u} = \mathbf{x}\mathbf{G}^{-1} = \mathbf{x}\mathbf{G}$$

Based on the equation 14 and the equation 16, the following equation may be defined.

<Equation 17>

$$\mathbf{u}\mathbf{H} = \mathbf{x}\mathbf{G}\mathbf{H} = 0$$

The equation 17 shows that the constraint of **x** by **GH** may be derived from the constraint of **u** by **H**. In other words, the parity check matrix **GH** for the codeword vector **x** may be checked from the parity check matrix **H** for the encoding input bit vector **u**. For brevity of expression, the parity check matrix for the codeword vector **x** will be written as V = **GH.** For example, the parity check matrix **V** = **GH** for the codeword vector **x** in the polar code example ( $\mathcal{A} = \{3,5,7\}$, $\mathcal{P} = \{6\}$, $\mathcal{F} = \{0,1, 2, 4\}$) of the continuous length $N = 8$ may be given by the equation 17 as follows.

<Equation 18>

$$\mathbf{V} = \mathbf{G}\mathbf{H} = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 0 & 0 & 0 & 1 & 0 \\ 1 & 0 & 0 & 0 & 1 & 0 & 0 & 0 \\ 1 & 1 & 0 & 0 & 1 & 0 & 1 & 0 \\ 1 & 0 & 1 & 0 & 1 & 0 & 1 & 0 \\ 1 & 1 & 1 & 0 & 1 & 0 & 1 & 0 \end{bmatrix}$$

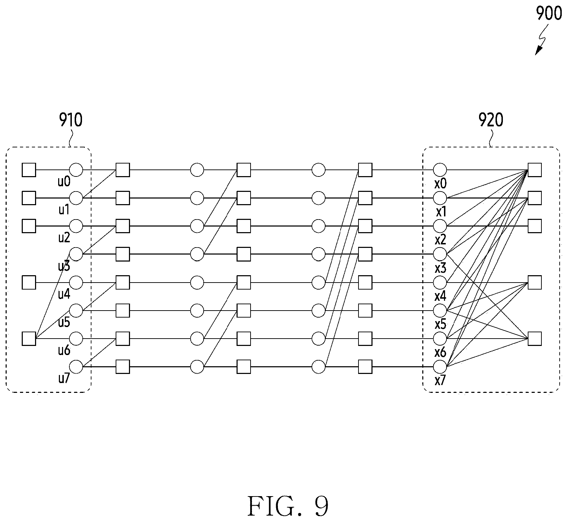

The constraints on **u** and **x** shown in the equation 14 and the equation 17 may be expressed on the polar code graph. Hereinafter, the constraints on **u** and x will be described with reference to FIG. 9.

FIG. 9 illustrates an example of a graph modified in consideration of future constraints in a polar code decoding method and device in a communication system or a broadcasting system according to embodiments of the disclosure.

Referring to FIG. 9, a constraint on **u** and **x** appearing in the pole code example ( $\mathcal{A}$ = {3,5, 7}, $\mathcal{P}$ = {6}, $\mathcal{F}$ = {0,1, 2, 4}) of the continuous length $N$ = 8 may be expressed on the pole code graph 900. The constraint 910 indicates five constraints (four fixed bits and one parity bit) on **u** by **H** of the above example of the equation 15 by connection lines related to the check node. For example, the constraint $u_3 \oplus u_5 \oplus u_6 = 0$ on the parity bit $u_6$ is represented as a check node connecting three variable nodes $u_3, u_5, u_6$ on the graph. The constraint 920 indicates five constraints on **u** by **V** of the above example of the equation 18 as connection lines related to the check node. For example, by the equation 17, the constraints $u_3 \oplus u_5 \oplus u_6 = 0$ are the same as $x_3 \oplus x_5 \oplus x_6 \oplus x_7 = 0$, and are represented as check nodes connecting four variable nodes $x_3, x_5, x_6, x_7$ in the polar code graph 900.

In the disclosure, the decoder may perform decoding based on at least one future constraint by identifying the constraint on the codeword vector **x**. Since the conventional SC-based decoding method and device sequentially decode bits of **u**, the future constraint bits located in **u** could not be structurally considered. For example, in decoding $u_3$, the constraint by the parity bit $u_6$ was not considered in the conventional SC-based decoding method and device. On the other hand, the decoder according to embodiments of the disclosure may transform the future constraint located in **u** into a corresponding constraint in the codeword vector **x**, as identified through the equation 17. The decoder according to embodiments of the present disclosure may increase the accuracy of decoding by performing decoding based on a result of the transformation. As shown in FIG. 9, the constraint on the codeword vector **x** may be used for decoding each bit of **u**.

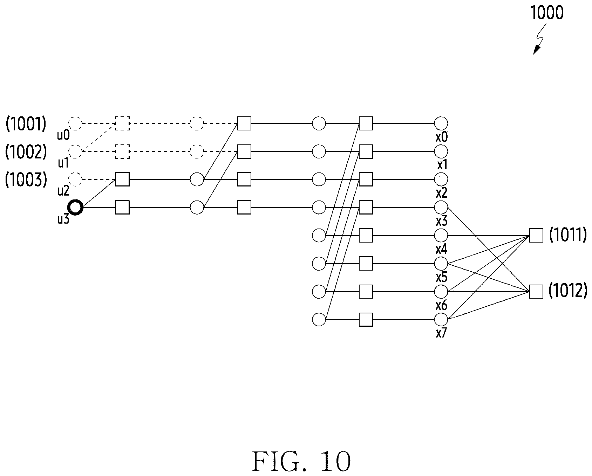

FIG. 10 illustrates an example of a graph considering a future constraint configured in decoding each bit in a polar code decoding method and device of a communication system or a broadcasting system according to embodiments of the disclosure. The SC-based decoding method and device according to embodiments of the disclosure may change and use the graph in which the constraint is displayed, upon processing each bit, as shown in FIG. 9.

Referring to FIG. 10, a graph 1000 configured when decoding an information bit $u_3$ in a continuous example ( $\mathcal{A}$ = {3,5,7}, $\mathcal{P}$ = {6}, $\mathcal{F}$ = {0,1,2,4}) is displayed. When decoding the information bit $u_3$ in the SC-based decoding method and device, the previously estimated $u_0, u_1, u_2$ are reflected as a variable node 1001, a variable node 1002, and a variable node 1003. Therefore, the constraints in **x** corresponding to the fixed bit and the parity bit already reflected in **u** may be excluded from the graph. In other words, in decoding of $u_3$, the future constraint bits are $u_4$ and $u_6$, and only the constraints in **x** corresponding thereto may be considered as a constraint 1011 and a constraint 1012.

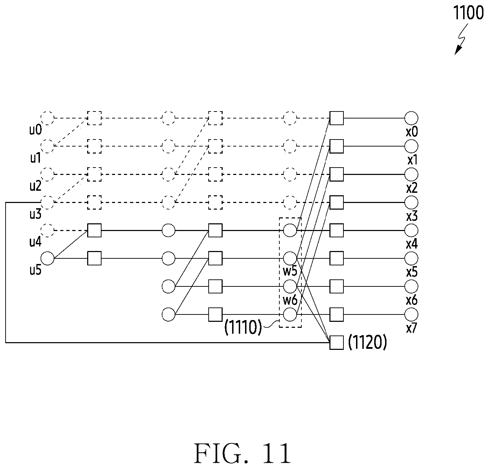

Further, the SC-based decoding method and device of the disclosure may utilize the future constraints in a subcode of the polar code, without necessarily considering the future constraints on **x** located in the rightmost step ($t = n$). Hereinafter, an example of a decoding process in which the future constraint is reflected in an intermediate stage rather than the rightmost step will be described with reference to FIG. 11.

FIG. 11 illustrates an example of a graph considering future constraints configured when decoding each bit in a polar code decoding method and device of a communication system or a broadcasting system according to embodiments of the disclosure. In decoding an information bit $u_5$ in the continuous example ( $\mathcal{A}$ = {3,5,7}, $\mathcal{P}$ = {6}, $\mathcal{F}$ = {0,1,2,4}), the future constraint is a parity bit $u_6$ generated as $u_3 \oplus u_5 \oplus u_6 = 0$. Since an estimated value $\hat{u}_3$ of $u_3$ may be used by sequential SC decoding, the constraint may be expressed again as $u_5 \oplus u_6 = \hat{u}_3$. However, in the constraint equation $u_5 \oplus u_6 = \hat{u}_3$, both of $u_5$ and $u_6$ belong to the second sub-code in the repetitive and stepwise configuration of the polar code. Here, the second sub-code is a code of a length $N$ = 4 generated by ($u_4, u_5, u_6, u_7$),

Referring to FIG. 11, a graph 1100 configured when decoding the information bit $u_3$ in the continuous example ( $\mathcal{A}$ = {3,5, 7}, $\mathcal{P}$ = {6}, $\mathcal{F}$ = {0,1,2,4}) is shown. The decoder generates a codeword corresponding to an intermediate variable node in a variable region 1110 (step $t$ = 2). Accordingly, a mathematical equation $u_5 \oplus u_6 = \hat{u}_3$ by the future constraint may be converted into and applied to $w_5 \oplus w_6 = \hat{u}_3$ in the step $t = 2$, as represented in a check node 1120 of FIG. 11, not $x_5 \oplus x_6 = \hat{u}_3$ in the step $t$ = 3. The decoder for the SC-based decoding method and device according to the embodiments of the disclosure may determine a location of the check node newly added by the future constraints by reflecting the structure of the sub-code as described above.

As in the above embodiments, the decoding method and device of the disclosure may perform an operation based on a graph of a polar code modified in consideration of the future constraints. The modification of the polar code includes at least one of general modification methods for a bipartite graph of a linear code, such as e.g., adding a check node and a connection line in consideration of future constraints, deleting a node and a connection line, merging two or more nodes, and deleting overlapping connection lines.

Decoding of the polar codes on the modified graph may be performed based on belief-propagation. In the conventional SC decoding, calculation of the LLR was performed only in one direction, e.g., from the right ($t = n$) to the left ($t = 0$) of the graph. However, as described above, as a new check node is added, a bi-directional LLR calculation becomes possible in the graph. This process is the same as, or a modification of, message passing decoding of a low-density parity-check (LDPC) code. It is also possible to exchange repetitive messages on this graph. In this context, a method of sequentially performing decoding by one bit through belief-propagation on the modified graph may be referred to as BP-SC decoding.

These two embodiments of the SCC decoding and the BP-SC decoding may be used in combination. The SCC decoding is characterized in that the decoding is reserved to reflect some future constraints in successive decoding and bit determination processes, and the BP-SC decoding is characterized in that a decoding graph used is modified and used based on the future constraints. Those two methods are not mutually exclusive and may be used together. For example, the SCC decoding and the BP-SC decoding may be combined to be realized in a BP-SCC decoding scheme.

Further, the embodiments of the disclosure are not exclusive to an extension of the conventional SC decoding methods as SCL decoding, SCS decoding, and SCF decoding, and may be used to extend and apply the embodiments of the disclosure to these methods. For example, the SCC decoding method, the BP-SC decoding method, and the BP-SCC decoding method may be combined with a scheme such as a list, a stack, or a flip that considers two or more candidate groups. Accordingly, other embodiments of the disclosure may be realized in a manner such as SCC-list, SCC-stack, SCC-flip, BP-SC-list, BP-SC-stack, BP-SC-flip, BP-SCC-list, BP-SCC-stack, BP-SCC-flip, or the like.

The decoding methods of the disclosure may be realized as a process of solving a constraint satisfaction problem (CSP) by utilizing a future constraint in a search process in a binary decision tree. As described above, SC decoding of a polar code may be understood as depth-first-search (DFS) that proceeds to a child node for an estimated value for each bit in the binary decision tree. In the conventional SC-based decoding, a search is performed by selecting one of child nodes having a high probability based on a metric such as the LLR or the like. On the other hand, the newly added check node in the graph modified in consideration of the future constraint may be used to determine the validity of an intermediate result obtained in the belief-propagation process. Accordingly, the SC-based decoding method and device utilizing the future constraint of the disclosure may identify whether the future constraint is satisfied ,by schemes of SCC, BP-SC, BP-SCC, or the like, and then perform a search for the binary decision tree based on the identification.

The search for the binary decision tree for the SC-based decoding of the disclosure may be performed according to the following scheme of an embodiment.

If only one of the nodes meets a given future constraint (or if it does not violate the future constraint), then the decoder proceeds to search for the node.

If two or more nodes meet the given future constraint (or if it does not violate the future constraint), the decoder may select one node according to a predetermined rule to proceed with the search. The predetermined rule may be a method of selecting one node based on a metric calculated in or derived from a decoding process. The predetermined rule may be a method of randomly selecting one of nodes. The predetermined rule may be a method of selecting a fixed one among nodes. Position, information, etc. of the nodes that meet the future constraint (or do not violate the future constraint) but are not selected by the rules may be stored and managed in a memory or the like, and these nodes may be visited or utilized when no node meets the future constraint (or when all nodes violate the future constraint) in a subsequent search.

If all child nodes do not meet the given future constraint (or violate the future constraint), according to an embodiment of the disclosure, the decoder may terminate the search and early terminate the decoding. In another embodiment of the disclosure, the decoder may perform backtracking to a node that has satisfied the future constraint (or does not violate the future constraint) in the previous search process but has not proceeded to or visited. This process may be understood as conflict-directed back jumping (CBJ). In this process, one of the nodes stored in the memory or the like may be selected according to a predetermined rule. The predetermined rule may be a method of randomly selecting one of the nodes stored in a memory or the like. The predetermined rule may be a method of selecting a closest node among nodes currently being searched by implementing the memory in a stack structure.

The aforementioned descriptions are examples of implementation using the future constraint in the SC-based decoding according to embodiments of the disclosure. It should be noted that embodiments of the disclosure may be realized by any method of utilizing future constraints in SC-based decoding of the polar code, and are not limited to a specific method.

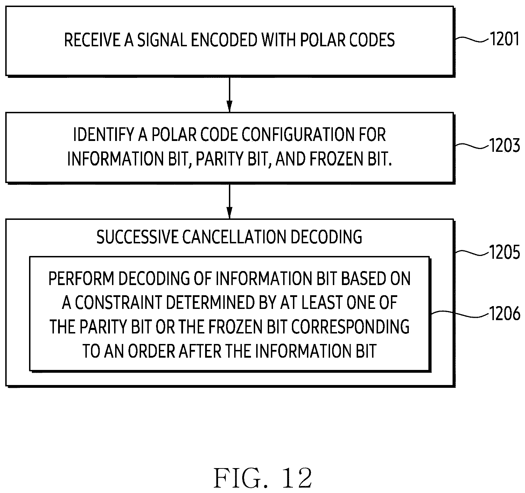

FIG. 12 illustrates an operation flow of a device for decoding based on future constraints according to embodiments of the disclosure. The device may include a decoder. In FIG. 12, a receiving device for receiving a signal is described as a decoder, but it is not interpreted that such a term excludes a transmission operation or an encoding operation of the receiving device. It goes without saying that the receiving device may operate as a transmitting device in relation to another device.

Referring to FIG. 12, in operation 1201, the device may receive a signal encoded with polar codes. The device may be a receiving device. The receiving device may receive a signal encoded with a polar code from a transmitting device. The signal may include a bitstream. The signal may include bit strings. The signal may include a plurality of bits. According to an embodiment, the signal may be a signal encoded based on a polar code. The signal may include an information bit. In order to be encoded to a size of N according to a specified condition ($N = 2^n$), a frozen bit may be used in addition to the information bit. The signal may include a frozen bit. A parity bit may be used to detect an error during a decoding process. The signal may include the parity bit. The transmitting device may be configured to align sub-channels based on a channel capacity (or reliability) and allocate information bits to a channel having a relatively large channel capacity (or reliability), thereby transmitting the signal encoded with the polar code.

In operation 1203, the device may identify a polar code configuration including an information bit and a parity bit. According to an embodiment, the polar code configuration may include bit index information. The bit index information indicates a bit index set of bits of a received signal. The bit index information may indicate an index of each information bit. For example, the bit index information may indicate an index set $\mathcal{A}$ of the encoding input bit assigned with the information bit. The bit index information may indicate an index of each parity bit. For example, the bit index information may indicate an index set $\mathcal{P}$ of the encoding input bit assigned with the parity bit. For example, the bit index information may indicate an index set $\mathcal{F}$ of the encoding input bit assigned with the frozen bit.

According to an embodiment, the polar code configuration may include operation scheme information. Parity bits may be used for error detection. The parity bits may be determined by a specific operation of other bits. According to an embodiment, the parity bits of the polar code may be causally generated. For example, the parity bit may be determined based on a linear combination of other bits. For example, in the example illustrated in FIG. 5, the parity bit $u_6$ is determined by an operation (i.e., $u_3 \oplus u_5$) of a linear combination of $u_3$ and $u_5$. The operation scheme information may indicate at least one of index information (e.g., 3, 5) or an operation scheme ($\oplus$) for the other bits.

According to an embodiment, unlike the above description, the parity bit may not be included in the signal. Since the parity bit is used in a concatenated polar code, it may not be used in a specific polar code. Accordingly, embodiments of the disclosure may include both an operation of decoding a signal including a parity bit and an operation of decoding a signal including no parity bit. According to an embodiment, when the parity bit is not included in the signal, that is, when the parity bit is not used for channel coding, the polar code configuration may not include the parity bit.

In operation 1205, the device may perform SC decoding (i.e., successive cancellation decoding). The SC decoding refers to an operation of sequentially decoding one bit by one bit, based on the previously estimated bits. The device may remove the estimated bit from the bit string and sequentially decode the bits one by one from the remaining bit. The SC decoding may be used to decode a signal encoded using the polar code.

According to embodiments, an operation of performing the SC decoding by the apparatus may include operation 1206. In operation 1206, decoding of the information bit may be performed based on a constraint determined by at least one of the parity bit or the frozen bit corresponding to an order subsequent to the information bit. Here, the parity bit or the frozen bit corresponding to the order subsequent to the information bit may be referred to as a future constraint (or a future constrained bit). Hereinafter, decoding of the information bit may be performed based on at least one value of at least one constrained bit.

The decoding of the information bit may be performed based on the value of the bit located behind the index of the information bit. In performing the SC decoding, a future constraint on the parity bit and/or the frozen bit according to embodiments of the disclosure may be used to estimate the information bit. Here, the parity bit and/or the frozen bit are located behind the information bit to be estimated. For example, when bits are indexed in ascending order, an index of the parity bit and/or the frozen bit may be greater than an index of the information bit.

The frozen bit has a fixed value. For example, all values of the frozen bits of the signal may be 0. For another example, all values of the frozen bits of the signal may be 1. The parity bit has a value determined according to a specified method. For example, the value of the parity bit may be determined through an operation on the information bits. As such, the frozen bit or the parity bit is limited based on the rule according to the polar code configuration.

In the SC decoding, the posterior-probability of the information bit is used. The device according to the embodiments of the disclosure may pre-determine a value of a constrained bit (i.e., a frozen bit or a parity bit corresponding to a decoding order subsequent to the information bit) and then perform decoding of the information bit, rather than considering all bit values. Since a posterior-probability calculation is utilized only for certain candidates other than all candidates (i.e., the marginalization of the equation 11), a result of decoding of the information bit may be more accurate.

While the SC decoding has been described as an embodiment heretofore, it goes without saying that the decoding principle according to the future constraints of the disclosure may be also applied to decoding techniques other than the SC decoding.

Hereinafter, a decoding technique utilizing the future constraint described above with reference to FIGS. 1 to 12 will be described in greater detail, using mathematical equations. To this end, the following additional mathematical signs and symbols are defined and used for vectors and matrices.

As described above, unless otherwise stated, it is assumed that the index of the first element of a vector, a matrix, or a sequence starts from 0.

For two non-negative integers $i$ and $j$, $\{i:j\}$ represents a set of consecutive integers from $i$ to $j$. When this symbol is used as a subscript to represent a set of elements of a vector and a matrix, it may be used in the form $i:j$ in which parentheses are omitted for more concise representation.

For a vector $\mathbf{a}$ and the two non-negative integers $i$ and $j$, $\mathbf{a}_i^j$ represents a sub-vector composed of an $i$-th element to a $j$-th element of the vector $\mathbf{a}$. In other words, it represents $\mathbf{a}_i^j = \left( a_i, a_{i+1}, \ldots, a_j \right)$, and may also be written

as $\mathbf{a}_{i,j}$ in another notation. If $i$ is less than $j$, then $\mathbf{a}_i^j$ is a NULL vector with a size of 0.

For the matrix $\mathbf{A}$ and the two non-negative integers $i$ and $j$, $\mathbf{A}_{i,j}$ represents an element in the $i$-th row and the $j$-th column of the matrix $\mathbf{A}$.

For a set $\mathcal{R},\mathcal{C}$ of the matrix $\mathbf{A}$ and the two non-negative integers, $\mathbf{A}_{\mathcal{R},\mathcal{C}}$ represents a submatrix including rows in which the index belongs to $\mathcal{R}$ and columns in which the index belongs to $\mathcal{C}$, in the matrix $\mathbf{A}$. The above definition is to represent slicing of the matrix.

For simple matrix slicing notation, a symbol $*$ is used. This symbol is used as a shortcut symbol representing a set of all rows or a set of all columns of a given matrix. In other words, for a matrix $\mathbf{A}$ of size $n \times m$, it represents

$$\mathbf{A}_{\mathcal{R},*} = \mathbf{A}_{\mathcal{R},0:m-1} \text{ and } \mathbf{A}_{*,\mathcal{C}} = \mathbf{A}_{0:n-1,\mathcal{C}}.$$

The detailed description of the disclosed invention will be made in greater detail based on the aforementioned additional mathematical symbol definition.

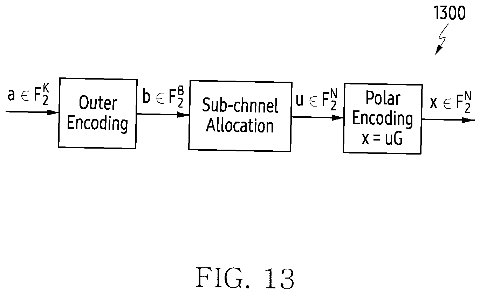

FIG. 13 illustrates an example 1300 of a concatenated polar coding system using an outer code according to embodiments of the disclosure.

Referring to FIG. 13, a given information vector $\mathbf{a} \in \mathbb{F}_2^K$ is first encoded by outer encoding and generates an outer codeword vector $\mathbf{b} \in \mathbb{F}_2^B$. The bits of the outer codeword vector are mapped to each position of an encoding input vector $\mathbf{u} \in \mathbb{F}_2^N$ of a length N. Here, the bits of the outer codeword vector are mapped to positions corresponding to a sub-channel having high reliability (or large channel-capacity) among sub-channels configured by channel polarization of the polar code, and the remaining bits are fixed bits with a fixed value. Thereafter, the encoding input vector is multiplied by the generation matrix $\mathbf{G} \in \mathbb{F}_2^{N \times N}$, and an encoding output vector (encoder output vector) or a codeword vector $\mathbf{x} \in \mathbb{F}_2^N$ is generated as a result of the multiplication.

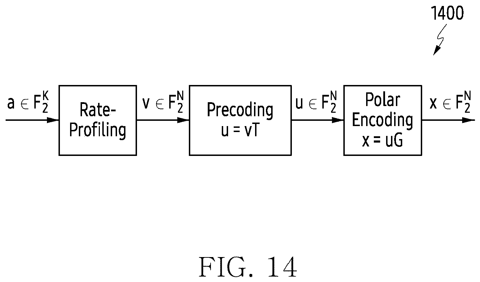

FIG. 14 illustrates an example 1400 of an equivalent model of a concatenated polar coding system using outer encoding according to embodiments of the disclosure. The concatenated polar coding system including the outer encoding described with reference to FIG. 13 may be represented by the equivalent model of FIG. 14. The given information vector $\mathbf{a} \in \mathbb{F}_2^K$ is first mapped to an extended vector $\mathbf{v} \in \mathbb{F}_2^N$ of length N through a process called rate profiling. Here, bit mapping may be performed in consideration of the characteristics, performance, etc. of the sub-channel by the channel polarization. An encoding input vector $\mathbf{u} \in \mathbb{F}_2^N$ may be generated by performing precoding on the extended vector $\mathbf{v}$, which is an output of the rate profiling. By the precoding, the extended vector $\mathbf{v}$ is multiplied by the precoding matrix $\mathbf{T} \in \mathbb{F}_2^{N \times N}$, thereby generating the encoding input vector $\mathbf{u} \in \mathbb{F}_2^N$. For example, the encoding input vector is generated as shown in the following equation.

<Equation 19>

$$\mathbf{u} = \mathbf{vT}$$

During the precoding process, one or more parity bits may be causally generated by the outer encoding. The subsequent process is substantially the same as the process in FIG. 13.

In other words, the equivalent model 1400 of FIG. 14 is represented by changing a combination of outer encoding and sub-channel allocation to a combination of rate profiling and precoding in the operation process of FIG. 13. Since each of the two system models generates the same output for the same input, the two system models are equivalent. However, the equivalent model 1400 of FIG. 14 (i.e., the rate profiling and precoding model) is advantageous to explain the embodiments of the disclosure in that outer encoding may be expressed as a matrix product. Hereinafter, embodiments of the disclosure will be described in detail using the equivalent model 1400 of FIG. 14.

As described above, the parity bits may be causally generated and disposed on the encoding input vector $\mathbf{u}$ by the outer encoding and the sub-channel allocation. Considering this process, each column of the precoding matrix is configured as follows, according to the type of a corresponding sub-channel.

For an index $i \in \mathcal{A}$ corresponding to an information bit, the $i$-th column is configured of $T_{i,i} = 0$ for $k$ where $T_{i,i} = 1$, $k \neq i$.

For an index $i \in \mathscr{F}$ corresponding to a fixed bit, all elements in the $i$-th column are configured of 0, that is, $\mathbf{T}_{*,i} = \mathbf{0}$.

For the index $i \in \mathscr{P}$ corresponding to the parity bit, $\mathbf{T}_{0:i-1,i}$ is configured to indicate that the parity bit $u_i$ is causally generated by $u_i = \mathbf{u}_0^{i-1} \mathbf{T}_{0:i-1,i}$. Further, $\mathbf{T}_{i:N-1,i} = \mathbf{0}$ is configured so that all the elements are zero.

For example, the precoding matrix $\mathbf{T}$ in the polar code example ( $\mathcal{A} = \{3,5,7\}$, $\mathcal{P} = \{6\}$, $\mathscr{F} = \{0,1,2,4\}$) of the continuous length $N = 8$ is given by the above rule as follows.

<Equation 20>

$$\mathbf{T} = \begin{bmatrix} 0 & 0 & 0 & 0 & 0 & 0 & 0 & 0 \\ 0 & 0 & 0 & 0 & 0 & 0 & 0 & 0 \\ 0 & 0 & 0 & 0 & 0 & 0 & 0 & 0 \\ 0 & 0 & 0 & 1 & 0 & 0 & 1 & 0 \\ 0 & 0 & 0 & 0 & 0 & 0 & 0 & 0 \\ 0 & 0 & 0 & 0 & 0 & 1 & 1 & 0 \\ 0 & 0 & 0 & 0 & 0 & 0 & 0 & 0 \\ 0 & 0 & 0 & 0 & 0 & 0 & 0 & 1 \end{bmatrix}$$

The entire generator matrix configured by a combination of precoding and polar encoding may be **TG.** For example, the entire generation matrix is given as follows.

<Equation 21>

$$\mathbf{TG} = \begin{bmatrix} 0 & 0 & 0 & 0 & 0 & 0 & 0 & 0 \\ 0 & 0 & 0 & 0 & 0 & 0 & 0 & 0 \\ 0 & 0 & 0 & 0 & 0 & 0 & 0 & 0 \\ 0 & 1 & 0 & 1 & 1 & 0 & 1 & 0 \\ 0 & 0 & 0 & 0 & 0 & 0 & 0 & 0 \\ 0 & 1 & 1 & 0 & 0 & 1 & 1 & 0 \\ 0 & 0 & 0 & 0 & 0 & 0 & 0 & 0 \\ 1 & 1 & 1 & 1 & 1 & 1 & 1 & 1 \end{bmatrix}$$

The precoding matrix **T** and the aforementioned parity check matrix **H** become a matrix in which all elements are 0, when multiplied by the definition. For example, the following relationship of equation is established based on the equation 19.

<Equation 22>

$$\mathbf{uH} = \mathbf{vTH} = \mathbf{0}$$

The column for the information bit in the parity check matrix **H** is all configured of 0 as described above, so the equation 22 (**uH** = 0) may be expressed in a simpler form as $\mathbf{uH}_{*,\mathcal{A}^c} = 0$. To this end, a simpler form such as $\mathbf{H'} = \mathbf{H}_{*,\mathcal{A}^c}$ may be defined and used.

The above-described SCC decoding process will now be described in greater detail based on the mathematical equations. Consider a step of decoding an information bit $u_i$ by successive decoding. As described above, the device of the SCC decoder may reflect the future constrained bit present between the next information bits, without immediately estimating $u_j$. For distinguishing of effective bits, a bit $u_j$ to be estimated may be referred to as a target bit, and a bit to be actually processed may be referred to as a processing bit. The index of the processing bit for the target bit $u_j$ is written as $\ell_j$, and this value is determined by the following equation.

<Equation 23>

$$\ell_i \triangleq \min\{k \geq i \mid (k+1 \in \mathcal{A}) \vee (k+1 = N)\}$$

If $\ell_j = i$, then the information bits are immediately arranged in succession, and the device has no future constraint to be considered in the middle, so the device may perform a general SC decoding. If $\ell_j > i$, then a hypothesis may be established that the value of the target bit $u_j$ is 0 and 1, respectively. Assume that a hypothesis that the value of the target bit $u_j$ is $b \in \{0,1\}$ is written as a symbol $\mathcal{H}_{i,b}$. For verification of the assumption $\mathcal{H}_{i,b}$, a temporary vector $\bar{u}\langle \mathcal{H}_{i,b}\rangle$ of length $\ell_j + 1$ may be generated. Based on the previously estimated vector $\hat{u}_0^{i-1} = (\hat{u}_0, \hat{u}_1, \dots, \hat{u}_{i-1})$, the temporary vector $\bar{u}\langle \mathcal{H}_{i,b}\rangle$ may be sequentially generated by the following equation.

<Equation 24>

$$\bar{u}\langle \mathcal{H}_{i,b}\rangle_j = \begin{cases} \hat{u}_j, & \text{for } j < i. \\ b, & \text{for } j = i. \\ \bar{u}\langle \mathcal{H}_{i,b}\rangle_0^{j-1} \cdot \mathbf{T}_{0:j-1,j}, & \text{for } i < j \leq \ell_i. \end{cases}$$

The configuration of the temporary vector $\bar{u}\langle \mathcal{H}_{i,b}\rangle$ may be generated based on the characteristic that the parity bit is causally generated.

The device for SCC decoding according to the embodiments may respectively perform the SC decoding, based on two temporary vectors $\bar{\bar{u}}\langle \mathcal{H}_{i,0}\rangle$ and $\bar{\bar{u}}\langle \mathcal{H}_{i,1}\rangle$ obtained by a process as in the equation 24 as above. The decoding process may be achieved by calculating a metric for the probability or determining the validity, when each temporary vector is reflected. By this series of processes, the SCC decoding process may be interpreted as performing decoding based on the improved transition probability as shown in the following equation.

<Equation 25>

$$W_N^{(i)}\left(\mathbf{y}, \hat{\mathbf{u}}_0^{i-1}, \bar{\mathbf{u}}\langle i, b\rangle_{i+1}^{\ell_i} \mid u_i = b\right)$$

The channel $W_N$ refers to a vector channel from $\mathbf{u}$ to $\mathbf{y}$ obtained through channel combining, and $W_N^{(i)}$ represents a sub-channel for $u_i$.

The future constraint conversion process for the above described BP-SC or BP-SCC decoding will now be described in detail based on the mathematical equations. As described above, the encoding input bit vector $\mathbf{u}$ is constrained in the relationship of $\mathbf{uH'} = \mathbf{0}$ for the parity check matrix $\mathbf{H'}$. It is also generated as an encoding output vector $\mathbf{x} = \mathbf{uG}$. Using these two relationships, an equivalent parity-check matrix $\mathbf{Q}$ for the encoding output vector is defined by the following equation.

<Equation 26>

$$\mathbf{Q} = \mathbf{GH'}$$

By this result, a parity check equation for the encoding output vector may be obtained as shown in the following equation.

<Equation 27>

$$\mathbf{xQ} = \mathbf{0}$$

The above parity check equation is obtained due to the characteristic that the generation matrix $\mathbf{G}$ is an involutory matrix, that is, $\mathbf{G} = \mathbf{G^{-1}}$.

In the polar code example ( $\mathcal{A} = \{3, 5, 7\}$, $\mathcal{P} = [6]$, $\mathcal{F} = \{0, 1, 2, 4\}$) of a continuous length $N = 8$, the parity check matrix $\mathbf{Q}$ for the encoding output vector is given as follows.

<Equation 28>

$$\mathbf{Q} = \begin{bmatrix} 1 & 1 & 1 & 1 & 1 & 1 & 1 & 1 \\ 0 & 1 & 0 & 1 & 0 & 1 & 0 & 1 \\ 0 & 0 & 1 & 1 & 0 & 0 & 1 & 1 \\ 0 & 0 & 0 & 0 & 1 & 1 & 1 & 1 \\ 0 & 0 & 0 & 1 & 0 & 1 & 1 & 1 \end{bmatrix}^{T}$$

Upon decoding of each information bit, the parity check equation (the equation 27) may be used while being modified. First, an index set of future constraint bits for any bit $u_i$ (not required to be an information bit) is written as $\mathcal{L}_i$, which is defined as follows.

<Equation 29>

$$\mathcal{L}_i \triangleq \{k \geq i \mid k \in \mathcal{A}^c\}$$

The parity check matrix modified for decoding of the information bit $u_i$ is written as $\mathbf{Q}^{(i)}$, which is given by the following equation.

<Equation 30>

$$\mathbf{Q}^{(i)} = \mathbf{G}_{*,i:N-1}\mathbf{H}_{i:N-1,\mathcal{L}_i}$$

Based on the above, the parity check formula configured upon decoding of the information bit $u_i$ is configured as follows.

<Equation 31>

$$\mathbf{\hat{u}}_0^{i-1}\mathbf{H}_{0:i-1,\mathcal{L}_i} + \mathbf{xQ}^{(i)} = 0$$

If SCC decoding is used to deal with a processing bit $u_{\ell_i}$ to estimate a target bit $u_i$, then the equation 31 may be rewritten as shown in the following equation.

**<Equation 32>**

$$\bar{\mathbf{u}}\langle \mathcal{H}_{i,b}\rangle \mathbf{H}_{0:\ell_i, \mathcal{L}_{\ell_i+1}} + \mathbf{x}\mathbf{Q}^{(\ell_i+1)} = 0$$

The parity check formulas given as in the equation 31 and the equation 32 may be utilized directly to decoding of the target bit $u_i$. The first term of each equation may be configured by the previously estimated bits and the assumed bits and may be obtained immediately. The second term may be configured by an encoding output vector by transforming the future constraints. Since the encoding output vector corresponds to the decoder input (LLR vector) in the decoder, the device may directly utilize the corresponding relationship. Therefore, since all terms are usable, the device may improve the decoding performance by utilizing the equation 31 and the equation 32.

The subgraph-based future constraint transformation will now be described in greater detail through the mathematical equations. To this end, several symbols are additionally defined. First, a start index of a subgraph of size $2^t$ including the encoding input bit $u_i$ may be expressed as $s(i,t) = 2^t \times \lfloor i/2^t \rfloor$ . Based on it, the index set of all bits belonging to the corresponding subgraph may be defined by the following equation.

**<Equation 33>**

$$\mathcal{T}(i,t) \triangleq \{s(i,t) + k \mid k \in \mathbb{Z}_{2^t}\}$$

By the above definition, a subgraph relationship of size $2^t$ included in the relationship x = uG of an entire polar code may be identified.

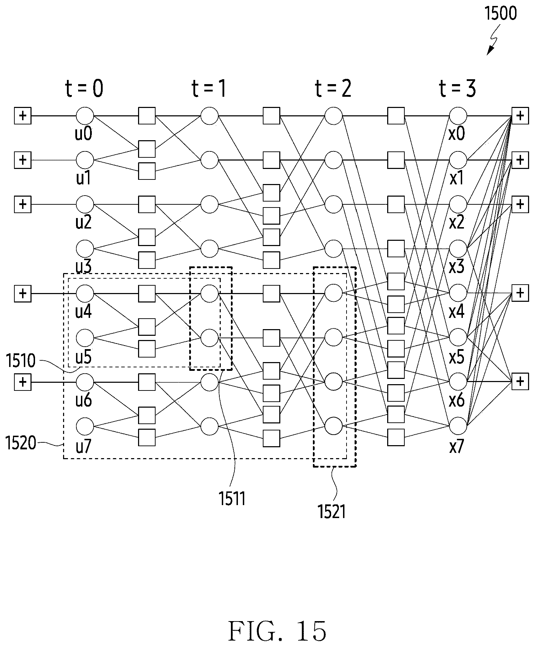

FIG. 15 illustrates an example of an intermediate codeword vector according to embodiments of the disclosure. First, $\mathbf{x}_i^{(t)}$ represents an intermediate codeword vector generated by a subgraph having a size $2^t$ including an encoding input bit $u_i$.

Referring to FIG. 15, the graph 1500 to which the example is reflected may include a subgraph 1510 and a subgraph 1520. The subgraph 1510 represents a subgraph of size 2 including $u_5$, and a vector (1511) $\mathbf{x}_5^{(1)}$ may be obtained in the step $t = 1$. Further, in FIG. 15, the subgraph 1520 represents a subgraph of size 4 including $u_5$, and a vector (1521) $\mathbf{x}_5^{(2)}$ may be obtained in the step t = 2. The following relational expression is obtained by recursive generation of polar codes.

**<Equation 34>**

$$\mathbf{x}_i^{(t)} = \mathbf{u}_{\mathcal{T}(i,t)}\mathbf{F}^{\otimes t}$$

wherein $\mathbf{x}_i^{(t)}$ represents an intermediate stage of vector generated by a subgraph of size $2^t$ including an encoding input bit $u_i$. For a set $\mathcal{A}$ of a vector **a** and non-negative integers, $\mathbf{a}_{\mathcal{A}}$ represents a sub-vector in which an index in an element of **a** is configured of elements belonging to the set $\mathcal{A}$. That is, it represents $\mathbf{a}_{\mathcal{A}} = (a_i : i \in \mathcal{A})$. That is to say, $\mathbf{u}_{\mathcal{T}(i,t)}$ means an encoding input bit vector of an index set of all bits belonging to a subgraph of size $2^t$ including an encoding input bit $u_i$, that is, a sub-vector of an input vector. As described above, $\mathbf{F}^{\otimes t}$ results from calculating t times of Kronecker power of $\mathbf{F} = \begin{bmatrix} 1 & 0 \\ 1 & 1 \end{bmatrix}$ , which is the same as the polar code generation matrix of size $2^t$.

Additionally, two index sets are defined as in the following equations.

<Equation 35>

$$\mathcal{T}'(i,t) \triangleq \mathcal{T}(i,t) \cap \{i : N-1\}$$

<Equation 36>

$$\mathcal{L}_{i,t} \triangleq \mathcal{L}_i \cap \left(\mathcal{T}(i,t) \backslash \mathcal{T}(i,t-1)\right)$$

Based on the definition of the set, the parity check matrix for an intermediate stage of codeword vector $\mathbf{x}_i^{(t)}$ generated by the subgraph of size $2^t$ including the encoding input bit $u_i$ is defined as in the equation below.

<Equation 37>

$$\mathbf{Q}^{(i,t)} = \left(\mathbf{F}^{\otimes t}\right)_{*,-s(i,t)+\mathcal{T}'(i,t)} \mathbf{H}_{\mathcal{T}'(i,t),\mathcal{L}_{i,t}}$$

Based on it, the transformed parity check equation for the subgraph of size $2^t$ including the encoding input bit $u_i$ may be obtained as shown in the following equation.

<Equation 38>

$$\hat{\mathbf{u}}_0^{i-1} \mathbf{H}_{0:i-1,\mathcal{L}_{i,t}} + \mathbf{x}_i^{(t)} \mathbf{Q}^{(i,t)} = \mathbf{0}$$

If SCC decoding is used to deal with a processing bit $u_{\ell_i}$ for estimation of the target bit $u_i$, the equation 38 may be rewritten as shown in the following equation.

<Equation 39>

$$\bar{\mathbf{u}} \langle \mathcal{H}_{i,b} \rangle \mathbf{H}_{0:\ell_i,\mathcal{L}_{\ell_i+1,t}} + \mathbf{x}_{\ell_i+1}^{(t)} \mathbf{Q}^{(\ell_i+1,t)} = \mathbf{0}$$

As with other parity check equations discussed above, all terms in the equation 38 and the equation 39 may be identified when decoding the target bit $u_i$. The decoder of the device may improve the decoding performance based on the result of the identification.

According to embodiments of the disclosure, a method performed by a device in a communication system or a broadcasting system may include receiving a signal including bits encoded based on polar codes. The method may include identifying a polar code configuration for at least one information bit and at least one frozen bit of the signal. The method may include performing decoding of the signal, based on the configuration of the polar codes. The decoding of the information bit of the at least one information bit may be performed based on at least one value of the at least one constraint bit. The at least one constraint bit may include at least one of a parity bit or the frozen bit corresponding to an order after the information bit.

According to an embodiment, each bit of the at least one constraint bit may be included in at least one parity bit or the at least one frozen bit of the signal.

According to an embodiment, the performing of the decoding may include determining a value of a constraint bit corresponding subsequent to the information bit, based on a previous decoding result of the information bit and candidate values of the information bit. The performing of the decoding may include performing decoding on the information bit, based on a value of the constraint bit.

According to an embodiment, the previous decoding result may include a value of a bit corresponding to an order before the information bit or a plurality of candidate groups of the bit.

According to an embodiment, when a constraint bit among the at least one constraint bit is a frozen bit, a value of the constraint bit may be determined as a fixed value. When a constraint bit among the at least one constraint bit is a parity bit, a value of the constraint bit may be determined based on a parity generation scheme.

According to an embodiment, decoding of the information bit may be performed based on an a-posteriori probability of the information bit. The a-posteriori probability may be derived based on the at least one value of the at least one constraint bit.

According to an embodiment, the polar code configuration may include bit index information for identifying each bit index of the at least one information bit and the at least one frozen bit.

According to an embodiment, the polar code configuration may include operation scheme information for error detection of at least one parity bit of the signal.

According to an embodiment, the polar code configuration may include information related to a parity check matrix for the signal and a generation matrix for the polar code.

According to an embodiment, an SC decoding may be performed based on a belief-propagation technique.

According to embodiments of the disclosure, a device performed by an apparatus in a communication system or a broadcasting system may include a memory, at least one transceiver, and at least one processor. The at least one processor may be configured to receive a signal including bits encoded based on polar codes. The at least one processor may be configured to identify a polar code configuration for at least one information bit and at least one frozen bit of the signal. The at least one processor may be configured to perform decoding of the signal, based on the polar code configuration. Decoding of an information bit among the at least one information bit may be performed based on at least one value of at least one constraint bit. The at least one constraint bit may include at least one of a parity bit or a frozen bit corresponding to an order after the information bit.

According to an embodiment, each bit of the at least one constraint bit may be included in at least one parity bit or the at least one frozen bit of the signal.

According to an embodiment, for performing the decoding, the at least one processor may be configured to determine a value of a constraint bit corresponding subsequent to the information bit, based on a previous decoding result of the information bit and candidate values of the information bit. For performing the decoding, the at least one processor may be configured to perform decoding on the information bit, based on the value of the constraint bit.

According to an embodiment, the previous decoding result may include a value of a bit corresponding to an order prior to a decoding order of the information bit or a plurality of candidate groups of the bit.

According to an embodiment, when a constraint bit among the at least one constraint bit is a frozen bit, a value of the constraint bit may be determined as a fixed value. When a constraint bit among the at least one constraint bit is a parity bit, a value of the constraint bit may be determined based on a parity generation scheme.

According to an embodiment, decoding of the information bit may be performed based on an a-posteriori probability of the information bit. The a-posteriori probability may be derived based on the at least one value of the at least one constraint bit.

According to an embodiment, the polar code configuration may include bit index information for identifying each bit index of the at least one information bit and the at least one frozen bit.

According to an embodiment, the polar code configuration may include operation scheme information for error detection of at least one parity bit of the signal.

According to an embodiment, the polar code configuration may include information related to a parity check matrix for the signal and a generation matrix for the polar code.

According to an embodiment, an SC decoding may be performed based on a belief-propagation technique.

According to embodiments of the disclosure, an operating method performed by a receiving device in a communication system or a broadcasting system may include receiving and processing a signal for bits encoded with a polar code to generate an input of the polar code, identifying a configuration of the polar code for the input, and performing successive cancellation (SC)-based decoding with a decoder input based on the identified configuration. In the SC-based decoding, decoding and estimation of at least one bit may be performed in consideration of a configuration (whether the bit is constrained or not, how the bit is constrained, or the like) of at least one bit to be later decoded and estimated. In particular, a successive decoding of the polar code proposed in the disclosure is performed in consideration of at least one of constrained bits whose values are not freely determined, so-called future constraint bits, among the bits to be later decoded and estimated.

The phrase 'a bit that is decoded and estimated after the bit to be decoded' may refer to a bit that is decoded later in time during a successive decoding process. According to a general notation, in case where a successive decoding process is referred to as an ascending order of a bit index, it refers to a bit with a larger index than the bit to be decoded. For example, in case where an $i$-th bit is to be decoded, an $(i + 1)$-th bit, an $(i + 2)$-th bit, and the like are 'a bit that is decoded and estimated afterwards'. In decoding of the $i$-th bit, the future constraint bit refers to a frozen bit (or a fixed bit) or a parity bit, of which value is constrained among bits having an index larger than $i$.

In an embodiment of the polar code decoding in consideration of the future constraints, the SC-check (SCC) decoding is configured to substitute a value that a bit to be decoded may have, 0 or 1, and identify or check whether all or at least one bit of the future constraint bits (with a small index) preceding the bit to be next decoded (having a small er index) t thereof has a corresponding constrained value.

In an embodiment of the SCC decoding, the decoder may substitute a value, 0 or 1, which the bit to be decoded (hereinafter, a target bit) may have, for a target bit, respectively. Thereafter, the decoder may substitute a bit value determined correspondingly for the future constraint bits. The decoder may identify or check whether a contradiction occurs in the configuration of the polar codes to estimate a value of the target bit. In other words, when '1' was substituted to the bit to be decoded and '1' was substituted to the bit to be decoded, the decoder may respectively check whether there arises a contradiction in the bit value determined correspondingly to the future constraint bits. The decoder may estimate the a target bit value as the bit where no contradiction arises.

In another embodiment of the SCC decoding, the decoder may substitute a value, 0 or 1, which the bit to be decoded may have, respectively for the target bit, substitute a correspondingly determined bit value for the future constraint bits, and then estimate the value of the target bit based on a metric capable of being calculated or derived from the configuration of the polar code. In other words, when substituting '0' for the bit to be decoded and substituting '1' for the bit to be decoded, the decoder may calculate a metric for the likelihood, a posteriori probability, or the like for the bit value determined correspondingly to the future constraint bits, and may determine an estimated value of the target bit with a larger metric value. The specific scheme of the SCC decoding is not limited to the above embodiments. The decoder may perform a method of determining based on at least one of subsequent bits, after substituting 0 and 1 respectively, without immediately estimating the bit to be decoded.

In another embodiment of the polar code decoding in consideration of the future constraint, the belief-propagation SC (BP-SC) decoding is a method of performing the SC decoding by adding a check node corresponding to at least one future constraint in the graph-based polar code decoding. In an embodiment of the BP-SC decoding, the decoder may perform a corresponding operation on a newly added check node to calculate a metric such as a log likelihood ratio (LR), thereby estimating a value for a target bit. In another embodiment of the BP-SC decoding, the decoder may perform iterative message passing on a graph to which a check node is added to calculate a metric such as an LLR for a bit to be decoded, thereby estimating the value for the target bit.

The SCC decoding and the BP-SC decoding may be combined to be realized by the BP-SCC decoding method. Further, the SCC decoding, the BP-SC decoding, and the BP-SCC decoding schemes may be combined with a method such as a list, a stack or the like considering two or more candidate groups, and may be realized by a scheme such as e.g., an SCC-list, an SCC-stack, an SCC-flip, a BP-SC-list, a BP-SC-stack, a BP-SC-flip, a BP-SCC-list, a BP-SCC-stack, a BP-SCC-flip or the like. It should be noted that embodiments of the disclosure may be realized by any method of utilizing future constraints in the SC-based decoding of polar codes, and are not limited to any specific scheme as described above.

A method performed by a receiving device in a communication system or a broadcasting system may include receiving and processing a signal for bits encoded with a polar code to generate an input for decoding of the polar code. The method may include identifying a configuration of the polar code for the input. The method may include performing decoding of the polar code based on the configuration of the polar code. The decoding operation of the polar code may be characterized by being performed based on a configuration of at least one next bit, when decoding at least one bit. According to an embodiment, the at least one next bit may be decoded and estimated later in time or order in successive decoding of the polar codes. According to an embodiment, a value of the at least one next bit may be a value determined or fixed by a predetermined scheme.

The disclosure relates to a communication system or a broadcasting system using a polar code. More particularly, the disclosure relates to decoding of a polar code in a communication and broadcasting system. An operating method of a receiving device may include receiving and processing a signal for bits encoded with a polar code to generate an input for decoding the polar code. The operation method may include identifying a configuration of the polar code for the input. The operation method may include performing decoding based on the identified configuration and the input for decoding the polar code. In the decoding process of the polar code, decoding of at least one bit may be performed in consideration of a configuration of at least one next bit. The at least one next bit used in the decoding is characterized in that it is a future constraint bit whose value is a constrained bit. The disclosure is characterized in that it is distinguished from a conventional polar code decoding method and device that do not consider future constraints.

The methods according to various embodiments described in the specification or claims of the disclosure may be implemented in hardware, software, or a combination of hardware and software.

When implemented as software, a computer-readable storage medium storing one or more programs (software modules) may be provided. One or more programs stored in the computer-readable storage medium are configured for execution by one or more processors in an electronic device. The one or more programs include instructions that cause the electronic device to execute methods according to embodiments described in the specification or claims of the disclosure.

These programs (software modules or software) may be stored in a random access memory, a non-volatile memory including a flash memory, a read only memory (ROM), an electrically erasable programmable read only memory (EEPROM), a magnetic disc storage device, a compact disc ROM (CD-ROM), digital versatile discs (DVDs), other types of optical storage devices, magnetic cassettes, or the like. Alternatively, it may be stored in a memory configured by a combination of some or all of those. In addition, a plurality of respective constituent memories may be included.

Further, the program may be stored in an attachable storage device that is accessible via a communication network such as e.g., Internet, Intranet, a local area network (LAN), a wide LAN (WLAN), or a storage area network (SAN), or a communication network configured with a combination of those. Such a storage device may make access to a device performing an embodiment of the disclosure via an external port. In addition, a separate storage device on a communication network may access the device performing embodiments of the disclosure.

In the above-described specific embodiments of the disclosure, an element included in the disclosure is expressed in a singular or plural form depending on a presented specific embodiment. However, the singular form or plural form is selected to suit its presented situation for the convenience of description, and the disclosure is not limited to the singular element or the plural element presented, and either a component expressed in plural may be configured in a singular form or a component expressed in singular may be configured in a plural form.

While specific embodiments have been described in the detailed description of the present disclosure, it will be apparently understood that many variations are possible without departing from the scope of the present disclosure.

**Claims**

1. A method performed by a device in a communication system or a broadcasting system, comprising:

   receiving a signal including bits encoded based on polar codes;
   identifying a polar code configuration for at least one information bit and at least one frozen bit of the signal; and
   performing decoding of the signal, based on the polar code configuration,
   wherein decoding of the information bit among the at least one information bit is performed based on at least one value of at least one constraint bit, and
   wherein the at least one constraint bit includes at least one of a parity bit or the frozen bit corresponding to an order after the information bit.

2. The method of claim 1, wherein each bit of the at least one constraint bit is included in at least one parity bit or the at least one frozen bit of the signal.

3. The method of claim 1, wherein the performing of the decoding comprises:

   determining a value of a constraint bit corresponding to an order after the information bit, based on a previous decoding result of the information bit and candidate values of the information bit; and
   performing decoding on the information bit, based on the value of the constraint bit.

4. The method of claim 3, wherein the previous decoding result includes a value of a bit corresponding to an order before the information bit or a plurality of candidate groups of the bit.

5. The method of claim 1,

   wherein when a constraint bit among the at least one constraint bit is a frozen bit, a value of the constraint bit is determined as a fixed value; and
   wherein when a constraint bit among the at least one constraint bit is a parity bit, a value of the constraint bit is determined based on a parity generation scheme.

6. A device performed by an apparatus in a communication system or a broadcasting system, comprising:

   a memory;
   at least one transceiver; and
   at least one processor,
   wherein the at least one processor is configured to:

      receive a signal including bits encoded based on polar codes;
      identify a polar code configuration for at least one information bit and at least one frozen bit of the signal; and
      perform decoding of the signal, based on the polar code configuration;

   wherein decoding of an information bit among the at least one information bit is performed based on at least one value of at least one constraint bit; and
   wherein the at least one constraint bit includes at least one of a parity bit or a frozen bit corresponding to an order after the information bit.

7. The device of claim 6, wherein each bit of the at least one constraint bit is included in at least one parity bit or the at least one frozen bit of the signal.

8. The device of claim 6, wherein, for performing the decoding, the at least one processor is configured to:

   determine a value of a constraint bit corresponding an order after the information bit, based on a previous decoding result of the information bit and candidate values of the information bit, and
   perform decoding on the information bit, based on the value of the constraint bit.

9. The device of claim 8, wherein the previous decoding result includes a value of a bit corresponding to an order prior to the information bit or a plurality of candidate groups of the bit.

10. The device of claim 6,

   wherein when a constraint bit among the at least one constraint bit is a frozen bit, a value of the constraint bit is determined as a fixed value, and
   wherein when a constraint bit among the at least one constraint bit is a parity bit, a value of the constraint bit is determined based on a parity generation scheme.

11. The device of claim 6,

   wherein decoding of the information bit is performed based on an a-posteriori probability of the information bit, and
   wherein the a-posteriori probability is derived based on the at least one value of the at least one constraint bit.

12. The device of claim 6, wherein the polar code configuration includes bit index information for identifying each bit index of the at least one information bit and the at least one frozen bit.

13. The device of claim 6, wherein the polar code configuration includes operation scheme information for error detection of at least one parity bit of the signal.

14. The device of claim 6, wherein the polar code configuration includes information related to a parity check matrix for the signal and a generation matrix for the polar code.

15. The device of claim 6, wherein SC decoding is performed based on a belief-propagation technique.

TRANSMITTING-END
(110)

RECEIVING-END
(120)

FIG. 1

RECEIVING-END (120)

COMMUNICATION
UNIT (210)

STORAGE
UNIT (220)

CONTROLLER
(230)

FIG. 2

FIG. 3

410

FUNCTION f (OR f')

420

FUNCTION g

430

SUCCESSIVE CANCELLATION

FIG. 4

| | |
|---|---|
| 0 | u0: frozen bit |
| 0 | u1: frozen bit |
| 0 | u2: frozen bit |
| 0            1 | u3: info. bit |
| 0            0 | u4: frozen bit |
| 0     1    0     1 | u5: info. bit |
| 0     1    1     0 | u6: parity bit |
| 0  1     0  1   0  1   0  1 | u7: info. bit |

500

FIG. 5

u0 = 0
u1 = 0
u2 = 0

600

u3 = 0

u3 = 1

610

601

u0 = 0
u1 = 0
u2 = 0

u3 = 0

u3 = 1

620

FIG. 6

FIG. 7

FIG. 8

FIG. 9

FIG. 10

FIG. 11

RECEIVE A SIGNAL ENCODED WITH POLAR CODES — 1201

IDENTIFY A POLAR CODE CONFIGURATION FOR INFORMATION BIT, PARITY BIT, AND FROZEN BIT. — 1203

SUCCESSIVE CANCELLATION DECODING — 1205

PERFORM DECODING OF INFORMATION BIT BASED ON A CONSTRAINT DETERMINED BY AT LEAST ONE OF THE PARITY BIT OR THE FROZEN BIT CORRESPONDING TO AN ORDER AFTER THE INFORMATION BIT — 1206

FIG. 12

1300

$a \in F_2^K$ → | Outer Encoding | → $b \in F_2^B$ | Sub-chnnel Allocation | → $u \in F_2^N$ | Polar Encoding $x = uG$ | → $x \in F_2^N$

FIG. 13

$$a \in F_2^K \longrightarrow \boxed{\begin{array}{c} \text{Rate-} \\ \text{Profiling} \end{array}} \xrightarrow{v \in F_2^N} \boxed{\begin{array}{c} \text{Precoding} \\ u = vT \end{array}} \xrightarrow{u \in F_2^N} \boxed{\begin{array}{c} \text{Polar} \\ \text{Encoding} \\ x = uG \end{array}} \xrightarrow{x \in F_2^N}$$

1400

FIG. 14

FIG. 15

## INTERNATIONAL SEARCH REPORT

| International application No. |
|---|
| **PCT/KR2023/004482** |

**A.  CLASSIFICATION OF SUBJECT MATTER**

**H03M 13/13**(2006.01)i; **H03M 13/39**(2006.01)i; **H03M 13/00**(2006.01)i

According to International Patent Classification (IPC) or to both national classification and IPC

**B.  FIELDS SEARCHED**

Minimum documentation searched (classification system followed by classification symbols)

H03M 13/13(2006.01); H03M 13/45(2006.01); H04L 1/00(2006.01); H04L 1/16(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 극부호(polar code), 정보 비트(information bit), 동결 비트(frozen bit), 제약 비트(constraint bit), 후순(posteriori), 패리티 비트(parity bit), 후보(candidate), error detection, bit index

**C.  DOCUMENTS CONSIDERED TO BE RELEVANT**

| Category* | Citation of document, with indication, where appropriate, of the relevant passages | Relevant to claim No. |
|---|---|---|
| X | KR 10-2019-0138682 A (QUALCOMM INCORPORATED) 13 December 2019 (2019-12-13)<br>   See paragraphs [0069] and [0123]-[0158]; claims 13-15; and figure 8. | 1-15 |
| A | HUAWEI et al. Details of the Polar code design. R1-1611254, 3GPP TSG RAN WG1 Meeting #87. Reno, USA. 03 November 2016.<br>   See sections 3-4.1. | 1-15 |
| A | INTERDIGITAL COMMUNICATIONS. Performance Evaluation of Channel Coding for URLLC and mMTC. R1-167565, 3GPP TSG RAN WG1 Meeting #86. Gothenburg, Sweden. 12 August 2016.<br>   See section 2.1. | 1-15 |
| A | US 2021-0376863 A1 (NATIONAL TAIWAN UNIVERSITY) 02 December 2021 (2021-12-02)<br>   See paragraphs [0026]-[0058]. | 1-15 |
| A | US 2019-0158222 A1 (HUAWEI TECHNOLOGIES CO., LTD.) 23 May 2019 (2019-05-23)<br>   See paragraphs [0037]-[0126]. | 1-15 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **14 June 2023** | **18 July 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/004482**

| Patent document cited in search report | | | Publication date (day/month/year) | Patent family member(s) | | | Publication date (day/month/year) |
|---|---|---|---|---|---|---|---|
| KR | 10-2019-0138682 | A | 13 December 2019 | BR | 112019021707 | A2 | 12 May 2020 |
| | | | | CA | 3056299 | A1 | 25 October 2018 |
| | | | | CN | 110546902 | A | 06 December 2019 |
| | | | | CN | 110546902 | B | 15 October 2021 |
| | | | | EP | 3613162 | A1 | 26 February 2020 |
| | | | | JP | 2020-518157 | A | 18 June 2020 |
| | | | | US | 11632193 | B2 | 18 April 2023 |
| | | | | US | 2020-0036477 | A1 | 30 January 2020 |
| | | | | WO | 2018-191908 | A1 | 25 October 2018 |
| | | | | WO | 2018-192514 | A1 | 25 October 2018 |
| | | | | WO | 2018-232562 | A1 | 27 December 2018 |
| US | 2021-0376863 | A1 | 02 December 2021 | TW | 202145723 | A | 01 December 2021 |
| | | | | TW | I731696 | B | 21 June 2021 |
| | | | | US | 11316540 | B2 | 26 April 2022 |
| US | 2019-0158222 | A1 | 23 May 2019 | CN | 109075803 | A | 21 December 2018 |
| | | | | CN | 109075803 | B | 06 November 2020 |
| | | | | EP | 3469714 | A1 | 17 April 2019 |
| | | | | EP | 3469714 | B1 | 30 December 2020 |
| | | | | US | 10784992 | B2 | 22 September 2020 |
| | | | | WO | 2018-021925 | A1 | 01 February 2018 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **E. ARIKAN**. Channel Polarization: a method for constructing capacity-achieving codes for symmetric binary-input memoryless channels. *IEEE Trans. Information Theory*, July 2009, vol. 55 (7), 3051-3073

- 3GPP, NR multiplexing and channel coding(Release 15). *TSG RAN TS38.212 v15.0.1*, February 2017
- **A. BALATSOUKAS-STIMMING** ; **M. B. PARIZI** ; **A. BURG**. LLR-based successive cancellation list decoding of polar codes. *IEEE Trans. Sig. Process*, June 2015, vol. 63 (19), 5165-5179